(19) Europäisches Patentamt / European Patent Office / Office européen des brevets

(11) **EP 2 786 411 B1**

(12) **FASCICULE DE BREVET EUROPEEN**

(45) Date de publication et mention de la délivrance du brevet:
**25.08.2021 Bulletin 2021/34**

(21) Numéro de dépôt: **12790575.0**

(22) Date de dépôt: **26.11.2012**

(51) Int Cl.:
**H01L 27/146** *(2006.01)*

(86) Numéro de dépôt international:
**PCT/EP2012/073632**

(87) Numéro de publication internationale:
**WO 2013/079447 (06.06.2013 Gazette 2013/23)**

(54) **DISPOSITIF A MATRICE DE DIODES A RESISTANCE D'ACCES ET STABILITE AMELIOREE**

ZUGRIFFSBESTÄNDIGE DIODENARRAYVORRICHTUNG MIT ERHÖHTER STABILITÄT

ACCESS-RESISTANT DIODE ARRAY DEVICE HAVING ENHANCED STABILITY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.11.2011 FR 1103618**

(43) Date de publication de la demande:
**08.10.2014 Bulletin 2014/41**

(73) Titulaire: **Commissariat à l'Énergie Atomique et aux Énergies Alternatives
75015 Paris (FR)**

(72) Inventeurs:
• **MOLLARD, Laurent
38640 Claix (FR)**
• **BAIER, Nicolas
F-38330 Biviers (FR)**
• **ROTHMAN, Johan
38000 Grenoble (FR)**

(74) Mandataire: **Ahner, Philippe et al
BREVALEX
95, rue d'Amsterdam
75378 Paris Cedex 8 (FR)**

(56) Documents cités:
**EP-A1- 1 677 353      EP-A1- 2 315 251
US-A1- 2010 148 289    US-A1- 2011 227 091**

• **Sheng S. Li: "Heavy doping effects in a degenerate semiconductor" In: "Semiconductor Physical Electronics", 1 janvier 2006 (2006-01-01), Springer Science + Business Media, LLC, USA, XP055049276, ISBN: 978-0-38-728893-2 page 128, le document en entier**
• **None**

## Description

## DOMAINE TECHNIQUE

La présente invention est relative au domaine des diodes fabriquées sur des substrats semi-conducteurs et agencées en une matrice de diodes. L'invention a trait plus précisément aux diodes de type p/n ou n/p qui peuvent être utilisées pour des imageurs dans le visible ou dans l'infrarouge.

## ÉTAT DE LA TECHNIQUE ANTÉRIEURE

Dans de nombreuses applications, les diodes sont agencées en matrices de diodes présentes sur un substrat. Dans une matrice, les diodes sont agencées en lignes et en colonnes.

Une matrice de diode peut être utilisée pour permettre une détection d'un rayonnement électromagnétique. Il peut en effet se former des paires électronstrous par interaction entre le rayonnement électromagnétique et le substrat. Cela permet l'apparition d'un courant proportionnel à une intensité du rayonnement incident. Chaque diode forme alors un pixel d'un imageur. Il est ainsi possible de fabriquer des imageurs dans le visible ou des imageurs infrarouge.

Inversement, une telle matrice peut être utilisée pour émettre un rayonnement électromagnétique lors du passage d'un courant dans chaque diode de façon à ce que la matrice forme une image. Chaque diode est alors un pixel d'un écran ou d'un afficheur, ou une partie d'un pixel si chaque pixel est composé de plusieurs émetteurs de rayonnement électromagnétique.

Il existe plusieurs types d'arrangements selon que les diodes sont agencées localement selon une symétrie axiale d'ordre quatre ou une symétrie axiale d'ordre six.

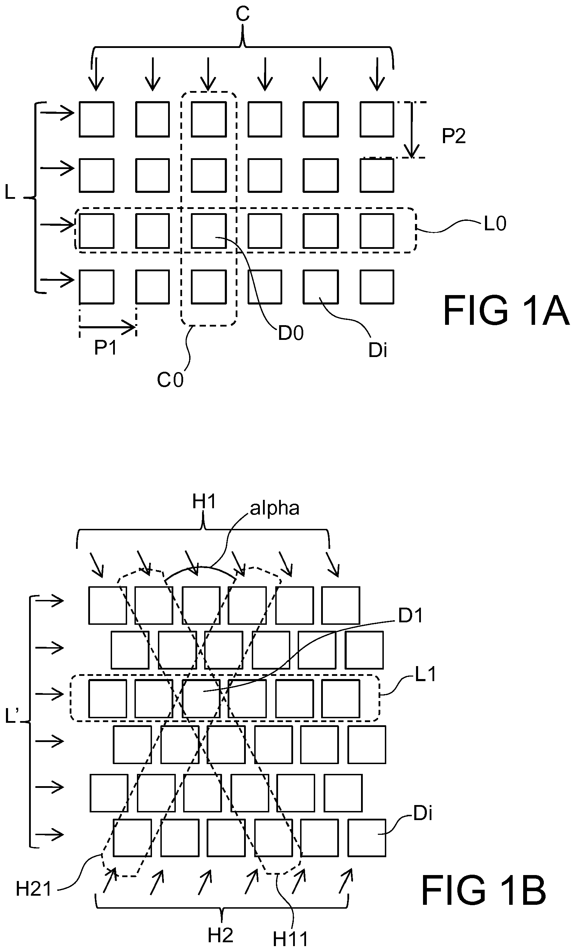

En figure 1A, il est représenté un agencement d'ordre 4 d'une matrice comportant des diodes Di. Chaque diode Di est à la croisée d'une ligne L et d'une colonne C qui forme avec la ligne un angle de 90° dans le plan de la matrice. Les diodes Di d'une ligne L sont alignées avec les diodes d'une autre ligne L voisine, formant ainsi les colonnes C. Dans la figure 1A, nous avons encadré une ligne L0 et une colonne C0, la diode nommée D0 est à la croisée de la ligne encadrée L0 et de la colonne encadrée C0. Cette configuration est classique et connue, c'est elle qui sera utilisée pour la description de l'invention dans un but de simplification. Les diodes d'une même ligne L sont séparées les unes des autres par un pas de ligne P1. Les diodes d'une même colonne C sont séparées les unes des autres par un pas de colonne P2. Ces pas sont qualifiés de pas « majoritaire » de ligne et pas majoritaire de colonne par opposition à un ou des pas « étendus » introduits plus loin. Si le pas majoritaire de ligne et le pas majoritaire de colonne sont sensiblement identiques, on peut alors parler de pas pixel en lieu et place des deux pas précités.

La figure 1B illustre un agencement de diodes en une matrice selon une symétrie axiale d'ordre 6. Dans cet exemple, les diodes D sont agencées en lignes L'. D'une ligne L' à une autre ligne voisine, les diodes Di ne sont pas alignées, mais décalées les unes par rapport aux autres. Ainsi, une diode Di d'une ligne L' est en regard avec deux diodes Di d'une ligne L' voisine. Un tel arrangement fait qu'il ne se forme pas de colonnes de diodes Di, mais une première diagonale H1 de diodes et une deuxième diagonale H2 de diodes ayant, dans le plan de la matrice, un angle donné alpha entre elles. Ici, les premières diagonales H1 sont représentées allant d'en haut à gauche vers en bas à droite de la figure 1B tandis que les deuxièmes diagonales H2 sont représentées allant d'en bas à gauche vers en haut à droite. Ainsi la diode référencée D1, est à la croisée d'une ligne L1 d'une première diagonale H11 et d'une deuxième diagonale H21 formant un angle donné alpha entre elles. L'angle donné alpha peut être sensiblement égal à 60°. Alors l'angle alpha sépare également les lignes L' des première et deuxième diagonales H1, H2.

Cet agencement de diodes ne sera pas particulièrement décrit dans la suite du document. Cependant, l'invention pourra s'y appliquer, les notions de lignes et de colonnes dans la suite de la description devant alors être remplacées par des notions de lignes, première diagonale et deuxième diagonale.

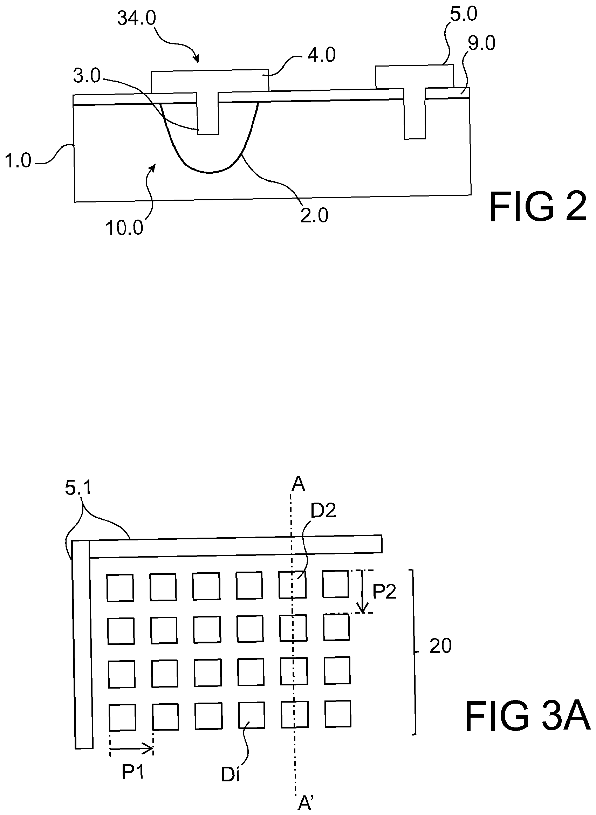

Une diode p/n, ou n/p, 10.0 telle qu'illustrée en figure 2, est présente sur un substrat 1.0 en un matériau semi-conducteur. On distingue dans le substrat 1.0 une première zone dopée, avec un premier type de dopage formée par la majorité du substrat et une deuxième zone dopée 2.0 comportant un dopant formant un deuxième type de dopage, le deuxième type de dopage étant opposé au premier type de dopage, respectivement p ou n pour une diode p/n ou une diode n/p. En général la deuxième zone dopée 2.0 est dopée avec une densité de dopage plus importante, de plusieurs ordres de grandeur, que le dopant formant le premier type de dopage dans le substrat 1.0. La deuxième zone dopée 2.0 forme une jonction p/n ou une jonction n/p avec le substrat 1.0. On considèrera qu'une diode 10.0 correspond à la jonction p/n, la deuxième zone dopée 2.0 et une zone de substrat présente autour de la deuxième zone dopée 2.0 et s'étendant sur au moins quelques nanomètres.

Au cœur de la zone dopée 2.0, un contact diode 34.0 permet de fournir ou de récupérer, tout courant circulant dans la diode 10.0. Le contact diode 34.0 comprend un pied 3.0 qui s'enfonce dans la deuxième zone dopée 2.0 et une tête 4.0 qui permet d'effectuer un contact électrique entre le pied 3.0 et une connexion électrique extérieure non représentée.

Une couche de passivation 9.0 est généralement présente entre le substrat 1.0, première et deuxième zones dopées confondues, et la tête 4.0 du contact diode 34.0. Sinon, il peut y avoir un contact électrique entre le contact diode 34, la deuxième zone dopée 2.0 et la première zone dopée du substrat 1.0. Cela conduirait à court-circuiter la diode.

Que la diode 10.0 soit utilisée en détection ou en émission, il est nécessaire qu'un courant puisse y circuler. Pour permettre une polarisation de la diode 10.0, il est nécessaire, en plus du contact diode 34.0 présent dans la zone dopée 2.0, de prévoir dans une partie du substrat extérieure à la diode 10.0, un contact substrat 5.0.

Le contact substrat 5.0 est destiné à être relié à un circuit électrique extérieur et permet d'imposer une polarisation de la diode 10.0. Le contact diode 34.0 et le contact substrat 5.0 forment ainsi deux bornes de la diode 10.0.

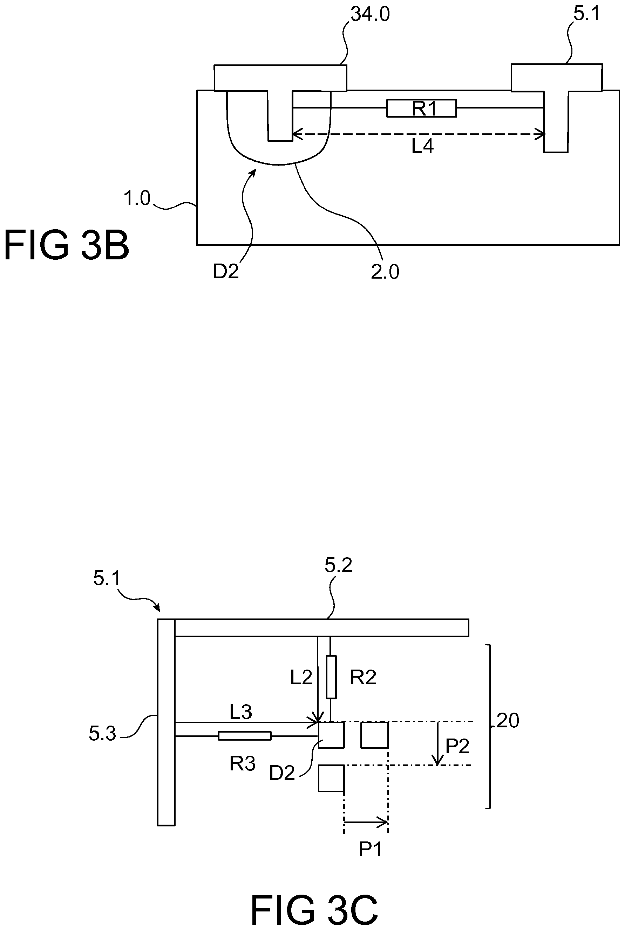

Lorsqu'il y a plusieurs diodes Di arrangées en une matrice, par exemple tel qu'illustré en figure 3A, le contact substrat est généralement en périphérie de la matrice 20 et mutualisé pour toutes les diodes Di de la matrice 20, on l'appellera alors contact substrat périphérique 5.1. Ce peut être par exemple une ligne conductrice bordant un, deux, trois ou quatre côtés de la matrice 20, si celle-ci définit un rectangle ou un carré dans le plan de la matrice. Ici, le contact substrat périphérique 5.1 est formé d'une ligne conductrice s'étendant sur deux côtés de la matrice 20.

Le pas majoritaire de lignes et le pas majoritaire de colonnes sont respectivement référencés P1 et P2.

La figure 3B est une coupe selon un axe AA' de la figure 3A dirigé selon une colonne, dans lequel il n'est représenté qu'une seule diode D2 de la colonne et une partie du contact substrat périphérique 5.1. La diode D2, comporte une zone dopée 2.0 présente dans le substrat 1.0 et un contact diode 34.0 pénétrant dans la zone dopée 2.0. Le contact diode 34.0 de la diode D2 est situé à une distance donnée du contact substrat périphérique 5.1, dite distance inter-contacts de bordure L4.

Pour utiliser les diodes, il faut les polariser comme on l'a déjà mentionné. La polarisation du contact diode 34.0 est effectuée par un circuit de lecture (non représenté) en contact avec une métallisation présente au dessus de toutes les diodes. Une polarisation substrat est effectuée par le circuit de lecture sur le contact substrat périphérique 5.1 présent autour de la matrice.

Une différence de potentiel formée entre le contact substrat périphérique 5.1 et le contact diode 34.0, s'applique au matériau du substrat 1.0 sur la distance inter-contacts de bordure L4. Le matériau du substrat 1.0 forme une résistance parasite de bordure R1 sur la distance L4 lorsqu'un courant parcourt le substrat entre la diode et le contact substrat périphérique 5.1. Cette résistance parasite R1 peut être considérée comme étant en série avec la diode D2.

La figure 3C représente un détail de la figure 3A, la diode D2 est représentée ainsi que deux diodes voisines, l'une sur la même ligne et l'autre sur la même colonne, permettant d'illustrer le pas de ligne P1 et le pas de colonne P2. Le contact substrat périphérique 5.1 est formé de deux branches de contact, une première branche de contact 5.2 selon les lignes et une deuxième branche de contact 5.3 selon les colonnes. La diode D2 est en série avec une première résistance parasite de bordure R2 la reliant à la première branche de contact 5.2 et avec une deuxième résistance parasite de bordure R3 la reliant à la deuxième branche de contact 5.3. Les deux résistances parasites de bordure R2 et R3 sont montées en parallèles. La résistance parasite de bordure R2 représente la traversée du substrat par le courant entre la diode D2 et la première branche de contact 5.2 sur une première distance inter-contacts de bordure L2. La résistance parasite de bordure R3 représente la traversée du substrat par le courant entre la diode D2 et la deuxième branche de contact 5.3 sur une deuxième distance inter-contacts de bordure L3.

Du fait des résistances parasites R1, R2, R3 non nulle et de valeurs différentes selon les diodes, on observe une dépolarisation de diodes situées plus au centre de la matrice comparativement aux diodes plus proches du contact substrat périphérique. Cette dépolarisation va être d'autant plus marquée que la matrice est de grand format ou que le substrat est en un matériau plus résistif. Toutes les diodes de la matrice ne subiront donc pas la même différence de potentiel. En conséquence, les diodes, en fonction de leur position sur la matrice, auront des réponses différentes. En particulier, les diodes les plus au centre de la matrice pourront être complètement dépolarisées.

Les diodes Di les plus dépolarisées auront généralement des performances réduites, par exemple un rendement réduit. Si les diodes sont photoémettrices elles pourront émettre avec une intensité lumineuse plus faible. Si les diodes sont photo-réceptrices, elles pourront avoir un courant de mesure affaibli lors d'une interaction avec un rayonnement électromagnétique, ou même un courant nul.

Dit autrement, du fait de cette dépolarisation, les diodes du bord et celles du centre de la matrice n'auront pas la même réponse pour un même rayonnement électromagnétique incident.

En particulier, lorsque les distances inter-contacts L2, L3 entre la diode D2 et le contact substrat périphérique 5.1 ont chacune une valeur proche de 20 ou 30 ou 50 fois la valeur du pas de ligne P1 ou du pas de colonne P2, les résistances parasites deviennent non négligeables si elles sont supérieures à une résistance critique. La distance inter-contacts conduisant à une résistance parasite de valeur égale à la résistance critique est appelée distance inter-contacts critique.

Pour des distances inter-contacts L2, L3 proches de 100 ou 500 fois le pas de ligne P1 ou de colonne P2, il peut être considéré que les distances inter-contacts L2, L3 sont trop importantes et induisent une dépolarisation totale de certaines diodes. Une conséquence particulière peut être de devoir augmenter une tension d'alimentation appliquée entre le contact diode 34.0 et le contact substrat 5.1, ce qui n'est pas toujours possible.

L'homme du métier sait, pour pallier toute difficulté générée par les résistances parasites, former des contacts substrat rapprochés au cœur de la matrice.

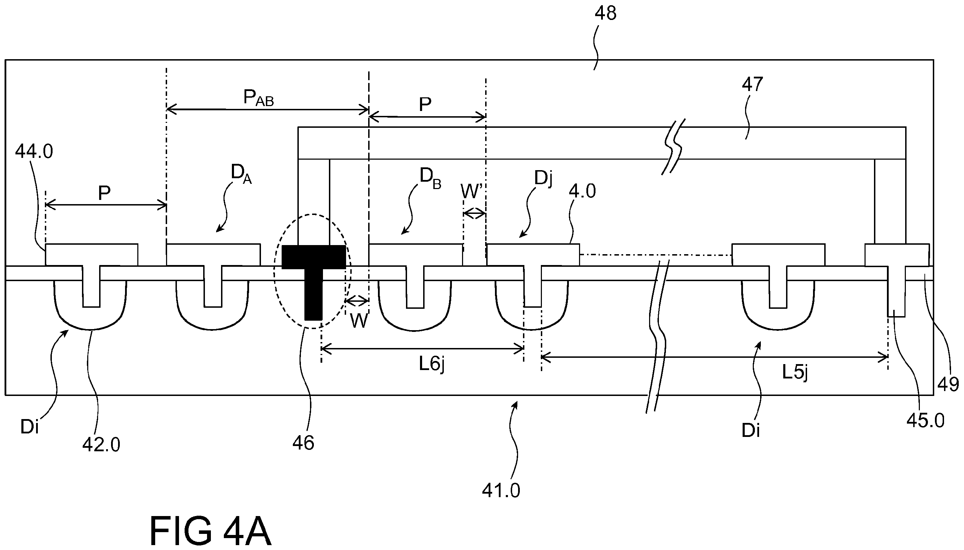

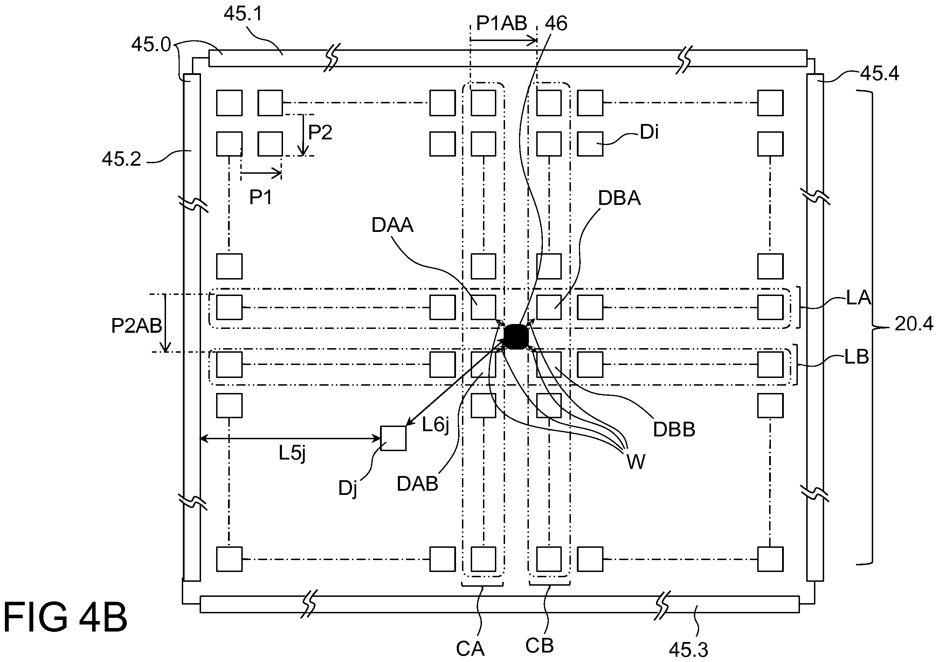

L'idée sous-tendant l'usage de contacts substrat rapprochés 46 est illustrée en figures 4A et 4B. Sur un substrat 41.0 sont présentes de multiples diodes Di, Dj, $D_A$, $D_B$, arrangées en une matrice. La figure 4A illustre une vue en coupe de la matrice, et la figure 4B une vue de dessus. On suppose que les diodes Di de la figure 4A appartiennent à une même ligne, elles pourraient cependant être sur une même colonne. De plus, toutes les diodes Di ne sont pas représentées, seules celles permettant de comprendre le principe des contacts substrat rapprochés 46 sont présentes sur la figure.

Chaque diode Di comporte une zone dopée 42.0 présente dans le substrat 41.0 et un contact diode 44.0 comportant une tête s'étendant sur la couche de passivation précitée 49, au-dessus de la zone dopée 42.0 et éventuellement au dessus du substrat 41.0 et un pied pénétrant dans la zone dopée 42.0. De plus, une couche diélectrique 48, en matériau diélectrique recouvre le substrat 41.0 et les têtes des contacts diode 44.0. Dans la suite de l'invention, par souci de simplification, la couche de passivation 49 est considérée comme étant présente, même si elle n'est pas représentée, sauf s'il est expressément dit le contraire.

Pour la majorité des diodes Di on prévoit un pas majoritaire de ligne P, permettant de mesurer une périodicité dans l'agencement des diodes Di à la surface du substrat 41.0 dans une même ligne.

On a représenté, à droite à l'extrémité de la ligne de diodes, en coupe, un contact substrat périphérique 45.0.

Entre deux diodes spécifiques, désignées ci-après comme étant une première diode $D_A$ et une deuxième diode $D_B$, il est inséré un contact substrat rapproché 46. Le contact substrat rapproché 46 est par exemple un plot conducteur, généralement métallique, ayant une partie qui pénètre dans le substrat 41.0. Le contact substrat rapproché 46 est situé à une distance minimale W de chacune des diodes $D_A$, $D_B$ qui l'encadrent. La distance minimale W est de préférence du même ordre de grandeur qu'une distance inter-diode W' entre deux diodes Di voisines. En première approximation, un contact substrat rapproché 46 peut avoir des dimensions du même ordre de grandeur que les contacts diode 44.0, ou il peut avoir des dimensions légèrement plus faibles ou plus grandes. Cependant, la présence du contact substrat rapproché 46 induit que les première et deuxième diodes $D_A$, $D_B$ encadrant le contact substrat rapproché 46 sont préférentiellement espacées d'un pas étendu $P_{AB}$ supérieur au pas majoritaire de ligne P entre deux diodes Di voisines dans le reste de la ligne.

Le contact substrat rapproché 46 est relié au contact substrat périphérique 45.0 au moyen d'une liaison électrique 47, par exemple une interconnexion, qui est positionnée de façon à ne relier électriquement aucun contact diode 44.0. Cette liaison électrique est réalisée dans ou sur la couche diélectrique 48.

Chaque diode Dj donnée est à une distance inter-contacts de bordure L5j de la branche du contact substrat périphérique 45.0 et à une distance inter-contacts interne L6j du contact substrat rapproché 46. Le contact substrat rapproché 46 est positionné de telle façon que pour chaque diode, au moins l'une de la distance inter-contacts de bordure L5j ou de la distance inter-contacts interne L6j est inférieure à la distance inter-contacts critique définie plus haut. La distance inter-contacts critique peut varier en fonction de la technologie de la microélectronique utilisée, ou en fonction d'une application visée, du matériau du substrat, d'une tension applicable entre les contacts diode 44.0 et soit les branches du contact substrat périphérique 45.0, soit les contacts substrat rapprochés 46, etc.

La figure 4B illustre la matrice 20.4 de diodes Di comportant en périphérie un contact substrat périphérique 45.0 formé de quatre branches de contact, respectivement désignées sous les références 45.1, 45.2, 45.3 et 45.4. La matrice 20.4 étant rectangulaire ou carrée, elle a quatre côtés, et chaque côté de la matrice 20.4 est bordé par une des branches de contact. Dans la matrice 20.4 toutes les diodes Di ne sont pas représentées. Il est uniquement représenté les diodes nécessaires à la compréhension.

En particulier, la matrice 20.4 est composée de lignes et de colonnes de diodes Di, chaque diode Di située à la croisée d'une ligne et d'une colonne donnée ayant au moins une diode voisine dans la même colonne et une diode voisine dans la même ligne. La plupart des diodes Di sont agencées périodiquement selon les lignes avec un pas majoritaire de ligne P1 et selon les colonnes avec un pas majoritaire de colonne P2 avec leurs diodes voisines.

La matrice 20.4 est composée d'un nombre de lignes et de colonnes de diodes tel qu'au moins une diode Dj a une distance inter-contacts de bordure L5j entre son contact diode et toutes les branches 45.1, 45.2, 45.3, 45.4 supérieure à la distance inter-contacts critique.

En un endroit de la matrice 20.4, par exemple à la croisée de deux lignes LA et LB et de deux colonnes CA et CB voisines il est inséré un contact substrat rapproché 46. Le contact substrat rapproché 46 peut être intercalé entre deux diodes voisines d'une même ligne, ou entre deux diodes voisines d'une même colonne. Il est alors respectivement présent entre les deux colonnes ou entre les deux lignes. Alternativement, comme illustré en figure 4B, le contact substrat rapproché 46 peut être situé à la croisée d'une paire de lignes avec une paire de colonnes.

Lorsque le contact substrat rapproché 46 est entre deux diodes DAA et DBA ou DAB et DBB d'une même ligne, le pas étendu P1AB entre ces deux dites diodes est plus important que le pas majoritaire de ligne P1 de la matrice.

Lorsque le contact substrat rapproché 46 est entre deux diodes DAA et DAB ou DBA et DBB d'une même colonne, le pas étendu P2AB entre ces deux dites diodes est plus important que le pas majoritaire de colonne P2 de la matrice.

Dans la figure 4B, le contact substrat rapproché 46 est représenté à la croisée d'une paire de lignes LA, LB et d'une paire de colonnes CA, CB. En conséquence, la matrice 20.4 comporte au moins deux perturbations importantes de périodicité d'agencement des diodes Di par contact rapproché 46 présent dans la matrice, l'une entre les lignes LA et LB et l'autre entre les colonnes CA et CB. Les lignes LA, LB et les colonnes CA, CB ont entre elles un pas étendu P1AB, P2AB, ces pas sont supérieurs aux pas de ligne majoritaire P1 et aux pas de colonne majoritaire P2, respectivement.

Le contact substrat rapproché 46, comme dans l'exemple de la figure 4A, est à une distance minimale W de toute diode voisine. De plus, le contact substrat rapproché 46 est inséré dans la matrice 20.4 de façon à ce que, pour toute diode Dj donnée de la matrice, il y ait au moins une distance, parmi une distance inter-contacts de bordure L5j et une distance inter-contacts interne L6j, qui soit inférieure à la distance inter-contacts critique.

S'il n'est pas possible, eut égard aux dimensions de la matrice 20.4, qu'un seul contact substrat rapproché 46 conduise à un tel résultat, on introduit généralement plusieurs contacts substrat rapprochés 46. Ainsi, de façon habituelle, les contacts substrat rapprochés 46 sont insérés en un réseau dans les matrices de diodes 20.4. Ce réseau est généralement dense. Si la distance inter-contacts critique est par exemple estimée à 15 pas pixels il est alors nécessaire, pour tenir compte d'effets de diagonales, d'avoir des contacts substrat rapprochés 46 approximativement toutes les 20 diodes.

Si cela est le cas, il y a alors dans la matrice 20.4 plusieurs perturbations de la périodicité de l'agencement des diodes Di. Cependant, si plusieurs contacts substrat rapprochés 46 sont alignés, par exemple entre deux même lignes ou entre deux même colonnes, une des perturbations de périodicité est induite de façon commune par les dits contacts substrat rapprochés.

Une matrice 20.4 comportant des contacts substrat rapprochés 46, est plus performante, avec une réponse plus homogène, qu'une matrice plus petite n'ayant pas besoin de contacts substrat rapprochés 46, mais comportant moins de diodes. Une telle matrice 20.4 est aussi plus performante qu'une matrice de mêmes dimensions n'ayant pas de contacts substrat rapprochés. Celle-ci a en effet certaines diodes moins efficaces, c'est-à-dire donnant, pour un même signal, une réponse plus faible que d'autres diodes. Cependant une matrice 20.4 comportant des contacts substrat rapprochés 46 comporte des défauts de périodicité comme on vient de le voir.

Dans le cas de technologies microélectroniques produisant des matrices ayant un pas important, par exemple supérieur à 15 μm, les pas étendus causés par l'insertion des contacts substrat 46 rapprochés peuvent, dans certaines conditions, être assimilés au pas pixel. Cependant, dans le cadre de matrices ayant un pas pixel inférieur ou égal à 15 μm, il n'est plus possible d'insérer des contacts substrat rapprochés 46 sans que la différence entre les pas étendus P1AB et P2AB et les pas majoritaires devienne trop importante et non négligeable.

Si la matrice est un imageur, ces défauts, issus d'une perturbation de la périodicité d'agencement des diodes, ont besoin d'être compensés par calcul de façon à observer une image électromagnétique et à en transmettre une représentation cohérente. Si la matrice est un émetteur, par exemple un écran, la perturbation de périodicité peut produire des images de qualité réduite ou qui nécessitent là aussi des traitements du signal importants pour masquer la perturbation.

De plus, la perturbation de périodicité conduit à former une matrice ayant une densité d'intégration de diodes réduite. En effet, plus il est introduit des contacts substrat rapprochés dans une surface donnée, plus il y a de diodes voisines ayant entre elles un pas étendu supérieur au pas de la matrice et moins il y a de diodes intégrées par unité de surface.

Enfin, les contacts substrat rapprochés 46 nécessitent d'être reliés au contact substrat périphérique 45.0 au moyen des liaisons électriques 47 précitées. Ces interconnexions encombrent la couche diélectrique 48 et rendent plus difficile la fabrication d'un circuit de lecture nécessaire pour polariser chaque contact diode 44.0.

Un moyen d'éviter, ou de réduire la perturbation de la périodicité est d'introduire chaque contact substrat rapproché en substitution d'une diode Di. Un tel montage permettrait d'éviter que certaines lignes et ou colonnes soient éloignées d'une ligne ou d'une colonne voisine de plus du pas de ligne ou du pas de colonne. Cependant, un tel montage introduit là aussi un défaut dans l'image électromagnétique observée ou émise, au moins une diode manquant à l'intérieur de la matrice. Pour ce faire, on peut soit créer un contact substrat rapproché 46 de toute pièce, soit utiliser une diode Di déjà formée, et en relier directement le contact diode 44.0 à une branche 45.1, 45.2, 45.3, 45.4 du contact substrat périphérique 45.0, Dans les deux cas, une surface correspondant à une diode Di n'est pas utilisable pour émettre ou recevoir une onde électromagnétique.

De plus, lorsqu'un contact substrat est fabriqué, certains procédés utilisés à cette fin, peuvent endommager les diodes situées à proximité du contact substrat. Ces diodes endommagées comportent alors des défauts qui entrainent des réductions de performances.

Enfin, l'interface entre le substrat et la couche diélectrique, isolante, est un paramètre clef de la performance des diodes. La performance des diodes est influencée par une interaction de porteurs minoritaires avec des défauts formant des états électroniques peu profonds, qui introduisent des effets de génération/recombinaison de porteurs, ou avec des états électroniques profonds, qui introduisent des effets de charge dans la couche diélectrique.

Les états électroniques peu profonds induisant une génération/ recombinaison de porteurs présents dans une zone de charge d'espace qui s'étend autour de la jonction p/n précitée, donnent lieu à des courants de fuite.

Les états électroniques peu profonds induisant une génération/recombinaison de porteurs présents en-dehors de ladite zone de charge d'espace forment un courant d'obscurité de diffusion plus important et une réponse plus lente de la diode.

Les effets de charge introduisent une modulation de l'interaction des porteurs avec les états électroniques induisant une génération/recombinaison de porteurs. Cela conduit à une modulation de la réponse de la diode et du courant d'obscurité. Cette modulation introduit dans la matrice un bruit temporel, souvent de type 1/f. Ladite modulation introduit aussi une variation de réponse moyenne des diodes, lors de variation de température de la diode au cours de plusieurs cycles d'utilisation. Cette variation de réponse moyenne est aussi appelée bruit de cyclage.

Les effets de charge peuvent encore induire une variation de dimensions de la zone de charge d'espace, par exemple en éloignant la zone de charge d'espace de part et d'autre de la jonction p/n. Ces variations de la zone de charge d'espace peuvent donner lieu elles aussi à des bruits temporels, des bruits spatiaux et des bruits de cyclage comme décrit dans le document « 1/f noise in HgCdTe Photodiodes » par M.A. Kinch et al publié en 2008 dans le Journal of electronic Material, volume 34, numéro 6, pages 928 et suivantes.

Dans le cas de photodiodes avec un substrat à gap constant, on cherche à réduire les effets de charge à l'interface entre le substrat et la couche diélectrique en optimisant un dopage présent dans le substrat et en cherchant à obtenir une couche diélectrique de meilleure qualité.

Ces options sont cependant peu efficaces et les effets de charge à l'interface restent un problème important pour la production de photodiodes avec un bon rendement.

L'effet de charge à l'interface peut cependant être réduit par l'utilisation d'hétéro-structures, dans lesquelles, à proximité de l'interface, il est utilisé un matériau ayant un gap plus important que le restant du substrat comme décrit dans le document « MBE HgCdTe Heterostructure p-on-n Planar Infrared Photodiodes », par J.M. Arias et al en 1993 dans le Journal of electronic Material, volume 22, numéro 8, pages 1049 et suivantes. Un gap plus important permet de diminuer l'interaction des porteurs minoritaires avec l'interface, ce qui permet de réduire la génération/recombinaison de porteurs. Cette méthode n'est applicable que pour des diodes p/n.

Pour les diodes n/p la seule solution est d'augmenter en surface la densité de dopant dans la première zone dopée du substrat pour en déplacer le niveau de Fermi. Cette construction n'est pas idéale mais elle est aussi applicable aux diodes p/n. Un défaut de ce type d'hétéro-structure par dopage d'une région surfacique du substrat est que la diode se retrouve en partie environnée de cette zone à fort dopage, avec pour conséquence d'augmenter les risques de courant de fuite. Il peut donc y avoir une perte de rendement importante.

Ces hétéro-structures restent cependant sensibles aux variations de dimensions de la zone de charge d'espace, même si elles peuvent y être moins sensibles. De plus, en fabriquant les hétéro-structures il est généralement introduit des défauts supplémentaires à l'interface entre le matériau du substrat et le matériau à gap plus important.

US 2011/227091 décrit un dispositif comportant un substrat portant une matrice de diodes, organisées en lignes et en colonnes, un contact substrat périphérique et plusieurs autres zones dopées formant des lignes conductrices; les lignes conductrices sont électriquement reliées au contact substrat périphérique et positionnées entre deux colonnes voisines de diodes et entre deux lignes voisines de diodes de manière à former un maillage de lignes conductrices.

EP1677353 A1, US2010/0148289 A1, EP2315251 A1 décrivent d'autres imageurs comportant des lignes conductrices entre des diodes.

## EXPOSÉ DE L'INVENTION

L'invention vise à réduire le défaut général des résistances parasites, à éviter la dépolarisation des diodes les plus éloignées du contact substrat et à permettre ainsi la production de matrices de diodes de grandes dimensions.

L'invention vise aussi à stabiliser l'interface stabiliser l'interface en diminuant les effets de charge. Les effets de charge sont situés au niveau d'une surface principale du substrat où sont les diodes, ou au niveau d'une interface entre le substrat et une couche diélectrique recouvrant le substrat et les diodes.

L'invention vise aussi à éliminer ou réduire les perturbations de périodicité induites par l'introduction de contacts substrat rapprochés.

L'invention vise également à diminuer l'interaction des porteurs minoritaires avec l'interface par la création d'une hétérostructure suite à une implantation ionique.

Pour y parvenir, l'invention concerne un dispositif selon la revendication 1.

De cette manière, on comprend bien que pour chaque diode, la résistance parasite perçue est répartie en deux composantes, une résistance parasite formée entre ladite diode et une ligne conductrice enterrée, et une résistance parasite formée par la ligne conductrice enterrée, mesurée entre le contact substrat périphérique et un point de la ligne conductrice enterrée situé le plus proche possible de la diode. Les lignes conductrices enterrées étant conductrices, elles ont une meilleure conductivité que le substrat et apportent donc une contribution à la résistance parasite plus faible que le substrat sur une même distance. De plus, en étant conductrices, les lignes conductrices enterrées permettent un premier mode d'action pour stabiliser l'interface en diminuant les effets de charge. Les effets de charge sont situés au niveau d'une surface principale du substrat où sont les diodes, ou au niveau d'une interface entre le substrat et une couche diélectrique recouvrant le substrat et les diodes.

Le fait que les lignes conductrices enterrées aient alors un dopage de type opposé à celui des deuxièmes zones dopées des diodes est avantageux. Cela permet un autre mode d'action pour stabiliser ladite interface.

On rappelle que le gap d'un matériau est défini comme la différence d'énergie entre le haut de la bande de valence et le bas de la bande de conduction. Dans le cadre d'un matériau semi-conducteur dégénéré la conductivité et la mobilité de porteurs sont d'un même ordre de grandeur que celles d'un métal.

Dans un matériau semi-conducteur dégénéré, le niveau de Fermi est situé dans une bande parmi la bande de conduction et la bande de valence et la position est fonction du dopage. Si le dopage est de type n+, le niveau de Fermi est situé dans la bande de conduction. On définit un gap effectif qui la différence d'énergie entre le niveau de Fermi situé dans la bande de conduction et l'état correspondant à la transition directe dans la bande de valence qui au premier ordre peut être assimilée au haut de la bande de valence. Dans le cadre d'un matériau dopé p+, du fait de la faible courbure de la bande de valence, on peut assimiler au premier ordre le gap et le gap effectif.

Dans la présente invention le terme « gap » est employé dans sa signification habituelle exposée plus haut pour les matériaux semi-conducteurs non dégénérés et il englobe le gap effectif dans le cas d'un matériau semi-conducteur dégénéré, surtout pour les matériaux semi-conducteurs dopés n+.

Si les lignes conductrices enterrées ont un gap plus important que le matériau environnant, cela crée une barrière de potentiel au niveau des lignes conductrices enterrées.

Grâce au maillage, on peut avoir des chemins de conduction d'une diode vers le contact substrat périphérique qui ne sont pas limités à une unique ligne conductrice enterrée.

Le substrat est en un matériau semi-conducteur, notamment du Si ou du SiC, du SiGe ou un matériau à base de $Hg_{1-x}Cd_xTe$, ou un substrat de type semi-conducteur sur isolant (par exemple du silicium sur isolant, SOI : silicon on insulator en anglais). Pour des diodes formées dans du $Hg_{1-x}Cd_xTe$, on utilisera de préférence un substrat de CdZnTe sur lequel est présente une couche superficielle de $Hg_{1-x}Cd_xTe$.

Dans ce cas avec un substrat dans un matériau semi-conducteur à un ou plusieurs éléments chimiques, la ligne conductrice enterrée est composée du ou des mêmes éléments chimiques que le matériau du substrat et est dopée avec un élément dopant, dit dopant de ligne.

Le dopant de ligne est présent avec une densité comprise entre $10^{15}$ et $10^{20}$ at/cm³. Ceci a plusieurs avantages. Un premier avantage est de ne pas nécessiter d'étape de gravure et d'être simple à implémenter. Un deuxième avantage est de pouvoir varier la conductivité des lignes conductrices enterrées en fonction de la densité de dopage utilisé. Un troisième avantage est qu'il est formé une barrière de potentiel au niveau de la ligne conductrice enterrée, c'est à dire au niveau de la surface précitée, fonctionnant comme encore un autre mode d'action afin de réduire les effets de charge et stabiliser ladite interface.

Dans une situation particulière, la ligne conductrice enterrée est en matériau semi-conducteur dégénéré. C'est-à-dire que la ligne conductrice enterrée a une densité de dopants telle que le matériau semi-conducteur a une conductivité et une mobilité de porteurs d'un même ordre de grandeur qu'un métal. En conséquence le matériau n'est plus semi-conducteur et ne présente plus de gap mais un gap dit effectif, comme on l'a vu plus haut. Ceci est avantageux car les lignes conductrices enterrées, reliées au contact substrat périphérique, ne contribuent alors pas ou peu à la résistance parasite. La résistance parasite ne dépend alors plus que d'une distance inter-contacts enterrée entre chaque diode et la ligne conductrice enterrée située la plus proche possible de ladite diode.

Si le substrat a au moins une couche superficielle en un matériau à base de $Hg_{1-x}Cd_xTe$ ayant principalement une première composition en cadmium, la ligne conductrice enterrée a avantageusement une deuxième composition en cadmium plus élevée que la première composition.

Elle est de préférence formée de manière auto-positionnée.

En augmentant la composition en cadmium dans un matériau en $Hg_{1-x}Cd_xTe$, on en augmente le gap.

On peut obtenir des zones ayant une deuxième composition en cadmium par autodiffusion du cadmium dans la ligne conductrice enterrée, initialement à la première composition en cadmium ayant un dopage de type p+. Il est alors formé, une hétérostructure auto-positionnée en tout point comportant un dopage de type p+, en particulier dans les lignes conductrices enterrées.

Si le substrat est en un matériau à base de $Hg_{1-x}Cd_xTe$, et si les lignes conductrices enterrées ont un dopage de type « p » ou de type « p+ », le dopant de ligne est avantageusement de l'arsenic. L'arsenic, dans les matériaux en $Hg_{1-x}Cd_xTe$, est un très bon dopant de type p. A l'inverse, si les lignes conductrices enterrées ont un dopage de type « n » ou de type « n+ », le dopant de ligne est avantageusement du bore. Le bore dans les matériaux en $Hg_{1-x}Cd_xTe$ est un très bon dopant de type n utilisable par implantation ionique.

On comprend que dans la proposition précédemment décrite, il est possible de former des matrices où à la fois les zones dopées des diodes et les lignes conductrices enterrées forment une hétérostructure autopositionnée à la deuxième composition en cadmium.

De façon avantageuse, les zones dopées des diodes et les lignes conductrices enterrées ont des dopages de type opposé. Seule l'une parmi les lignes conductrices enterrées et les zones dopées peut alors être de type p+ permettant la formation d'hétérostructures autopositionnées. Alors, de préférence, seules les lignes conductrices enterrées sont à la deuxième composition en cadmium.

De façon avantageuse, les lignes conductrices enterrées affleurent la surface principale du substrat d'un côté où sont présentes les diodes. Ladite surface peut être une interface entre le substrat et une couche diélectrique recouvrant les diodes et le substrat tel que préexposé plus haut. De cette façon, en étant proches de ladite surface ou interface, les lignes conductrices enterrées influent plus aisément pour réduire et/ou diffuser les effets de charge et stabiliser ladite surface ou interface.

De façon alternative, la ligne conductrice enterrée est enterrée dans le substrat, séparée de la surface principale par une épaisseur donnée de matériau du substrat. Les lignes conductrices enterrées sont alors bien entendu du côté de la surface ou interface du substrat où sont présentes les diodes. Cette alternative est avantageuse en ce qu'elle permet d'éloigner les lignes conductrices enterrées des contacts diode présents au niveau de ladite surface ou interface. Les lignes conductrices enterrées sont de plus protégées d'attaques ou de perturbations pouvant avoir lieu au niveau de ladite surface ou interface.

Un dispositif selon l'invention comporte avantageusement une ligne conductrice enterrée entre deux colonnes voisines de diodes et/ou lignes voisines de diodes au moins toutes les k colonnes et/ou les m lignes de la matrice, k et m peuvent valoir par exemple trente, deux ou un. Il est ainsi possible de former une matrice dans laquelle toutes les diodes sont à une distance inter-contacts enterrée d'une ligne conductrice enterrée inférieure à la distance inter-contacts critique.

De façon avantageuse, chaque ligne conductrice enterrée, présente entre deux lignes voisines de longueur donnée ou entre deux colonnes voisines de longueur donnée, a une longueur supérieure ou égale à la longueur desdites colonnes ou desdites lignes. Cela permet que les lignes conductrices enterrées relient deux branches de contact du contact substrat périphérique situées sur des côtés opposés de la matrice. Une ligne conductrice enterrée ayant deux extrémités, certaines lignes conductrices enterrées peuvent être reliées électriquement au contact substrat périphérique par leurs deux extrémités. Inversement, il peut être avantageux que certaines lignes conductrices enterrées aient une longueur inférieure à celle des lignes et/ou des colonnes. De telles lignes conductrices enterrées peuvent alors n'être en contact électrique direct qu'avec une unique branche de contact. Certaines d'entres elles peuvent être en contact électrique indirect avec le contact substrat périphérique en n'étant reliées au contact substrat périphérique que par l'intermédiaire d'autres lignes conductrices enterrées ou par des contacts substrat rapprochés. Cela a un intérêt si l'on désire avoir un maillage dense de lignes conductrices enterrées en un premier endroit de la matrice et un maillage plus relâché en un autre endroit de la matrice.

Les lignes conductrices enterrées ont, définies dans un plan contenant les diodes, une longueur et une largeur, la largeur est perpendiculaire à la longueur. En technologie « pas pixel 15 $\mu$m », la largeur est de préférence comprise entre environ 0,5 $\mu$m et 5 $\mu$m.

Les lignes conductrices enterrées ont une épaisseur, définie sensiblement suivant une normale à un plan contenant les diodes. En technologie « pas pixel 15 $\mu$m » l'épaisseur est comprise de préférence entre environ 0,5 $\mu$m et 2 $\mu$m.

Les lignes conductrices enterrées peuvent dans certains cas être reliées électriquement à un ou plusieurs contacts substrat rapprochés présents dans la matrice. Les contacts substrat rapprochés sont alors en contact électrique avec au moins une ligne conductrice enterrée. Ils sont reliés de préférence électriquement au contact substrat périphérique par des liaisons électriques autres que les lignes conductrices enterrées. On peut ainsi former des matrices de très grande surface comportant un nombre important de diodes, même avec des lignes conductrices enterrées qui ne sont pas en matériau semi-conducteur dégénéré ou dont la hauteur et la largeur sont trop faibles. De telles lignes conductrices enterrées pourraient en effet, si elles ont une grande longueur, avoir un impact non négligeable sur la résistance parasite.

En créant des contacts substrat rapprochés, il est possible de réduire dans les lignes conductrices enterrées la longueur contribuant à la résistance parasite pour une diode donnée. L'avantage de l'invention vis-à-vis de l'état de la technique sur ce point est que grâce à l'utilisation de lignes conductrices enterrées, beaucoup moins de contacts substrat rapprochés sont nécessaires. Il y a donc selon l'invention une réduction du nombre et de la fréquence des perturbations de périodicité induites par l'usage de contacts substrat rapprochés par rapport à l'état de la technique.

Si les lignes conductrices enterrées forment un maillage et si un ou plusieurs contacts substrat rapprochés sont présents dans la matrice, les contacts substrat rapprochés peuvent être insérés entre deux lignes voisines et/ou deux colonnes voisines ou peuvent être en substitution d'une diode.

## BRÈVE DESCRIPTION DES DESSINS

L'invention sera mieux comprise, et d'autres détails, avantages et caractéristiques de celle-ci apparaîtront à la lecture de la description suivante faite à titre d'exemple non limitatif et en référence aux dessins annexés dans lesquels :

Les figures 1A et 1B illustrent deux façons d'agencer des diodes en une matrice, soit en lignes et en colonnes, soit avec une symétrie axiale d'ordre trois,

la figure 2 est un schéma de structure d'une diode,

les figures 3A à 3C sont illustratives d'un problème générique selon l'état de la technique lié à la formation d'une résistance parasite liée à chaque diode, les figures 3A et 3C étant des vues de dessus d'une matrice de diodes et la figure 3B représentant une coupe d'une matrice de diodes,

les figures 4A et 4B illustrent respectivement en coupe et en vue de dessus une matrice de diodes selon l'état de la technique comportant un contact substrat rapproché,

les figures 5A et 5B illustrent respectivement en vue de dessus et en coupe une matrice de diodes selon un mode de réalisation qui ne fait pas partie de l'invention comportant entre deux colonnes de diodes voisines une ligne conductrice enterrée,

les figures 6, 7 et 8 illustrent trois exemples de modes de réalisation du dispositif qui ne font pas partie de l'invention comportant plusieurs lignes conductrices enterrées agencés toutes les k lignes et m colonnes de diodes, k et m ayant une même valeur dans ces exemples, et valant respectivement 30, 2 et 1.

Des parties identiques, similaires ou équivalentes des différentes figures portent les mêmes références numériques de façon à faciliter le passage d'une figure à l'autre.

L'invention est définie par les revendications.

Les figures sont utiles à la compréhension de l'invention. Elles illustrent chacune au moins un aspect de cette dernière.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

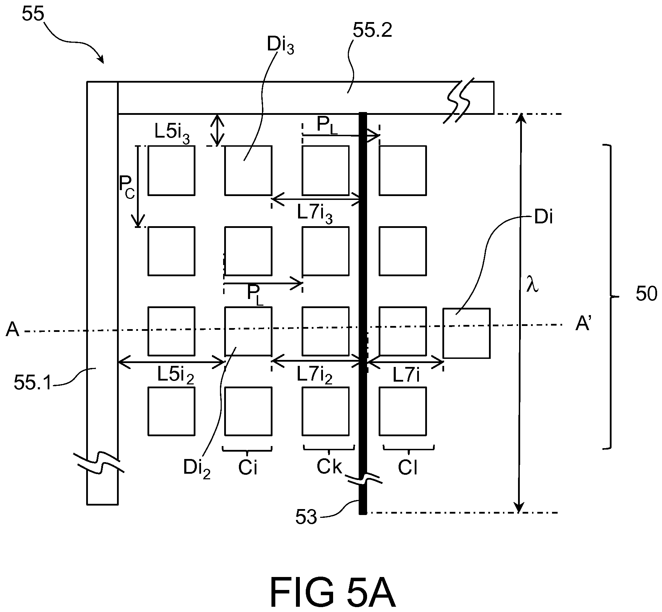

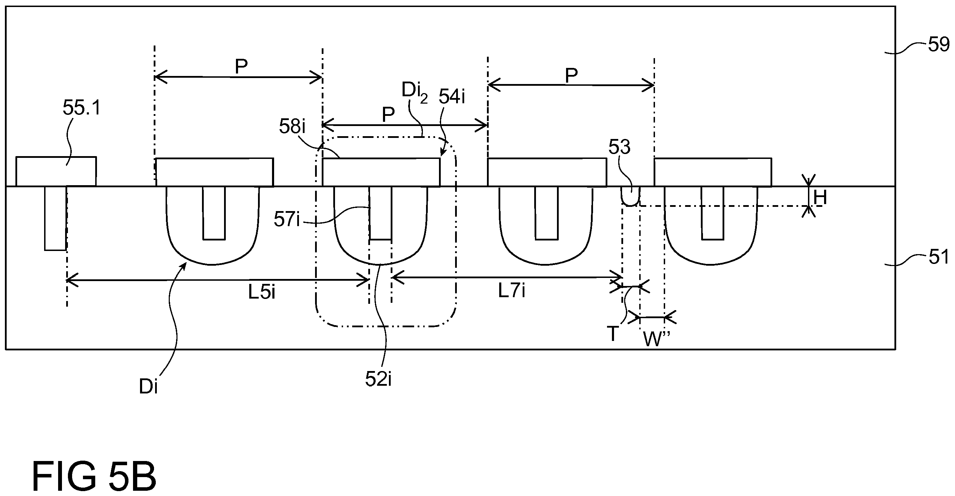

En premier lieu, un mode de réalisation qui ne fait pas partie de l'invention concerne une matrice de diodes telle que décrite en figures 5A et 5B.

La description relative aux figures 5A et 5B ne se rapporte pas à proprement parler à l'invention, puisque certaines caractéristiques de l'invention sont manquantes. Pour autant, cette description s'applique de la même manière à l'invention.

La figure 5A illustre en vue de dessus une matrice 50 de diodes Di. Celles-ci sont disposées sur un substrat représenté de façon non délimitée et sont agencées en lignes (Li) et en colonnes (Ci, Ck, Cl). Dans la figure 5A il est représenté, par esprit de simplification, dix-sept diodes Di, distribuées en quatre lignes et quatre colonnes plus une diode. Cependant, l'exemple est valable pour tout arrangement et tout nombre de diodes sur plusieurs lignes et plusieurs colonnes. Chaque diode comporte en surface un contact diode permettant une prise de contact électrique entre la diode Di et un circuit électrique ou électronique non représenté. La figure 5A étant une vue de dessus de la matrice 50 de diodes, seuls les contacts diode sont représentés, car ce sont les seules parties dépassant d'une surface principale du substrat. Pour faciliter la compréhension de la figure, dans la suite de la description, pour les vues de dessus, les contacts diode représentés seront assimilés à leur diode Di respective.

Les diodes Di sont agencées périodiquement dans la matrice 50 avec un pas majoritaire de ligne $P_L$ dans une même ligne et avec un pas majoritaire de colonne $P_C$ dans une même colonne. Dans la suite, il sera considéré par esprit de simplification que le pas majoritaire de colonne $P_C$ et le pas majoritaire de ligne $P_L$ sont sensiblement égaux; leur valeur sera dénommée par l'appellation « pas pixel P ». Cependant, dans le cas où le pas majoritaire de ligne et le pas majoritaire de colonne sont différents, l'exemple reste applicable, l'homme du métier sachant appliquer les enseignements de l'exemple à une matrice 50 où le pas majoritaire de colonne $P_C$ et le pas majoritaire de ligne $P_L$ sont différents. De plus, comme annoncé précédemment, les diodes peuvent être arrangées en premières diagonales, en deuxièmes diagonales et en lignes et non uniquement en lignes et en colonnes. L'homme du métier saura aisément appliquer les enseignements de l'exemple à une telle matrice.

La matrice 50 comporte en périphérie un contact substrat périphérique 55. Celui-ci est composé, dans l'exemple de cette figure, de deux branches de contact 55.1, 55.2 qui bordent la matrice 50 sur deux côtés successifs. Alternativement, le contact substrat périphérique 55 pourrait comporter une seule branche de contact, trois ou quatre branches de contact ou plus et ainsi border la matrice 50 sur autant de côtés, successifs, opposés ou autres.

Il est considéré que dans la matrice 50, au moins une diode Di est située à une distance inter-contacts de bordure de toute branche du contact substrat périphérique 55.1, 55.2 supérieure à une distance inter-contacts critique. La distance inter-contacts critique est telle qu'elle a été définie plus haut. Cela signifie qu'au moins une des diodes Di est trop éloignée de toute branche de contact 55.1, 55.2 pour que la diode ait des performances acceptables lors de son utilisation. Il s'agit par exemple d'une diode Di située dans une partie centrale de la matrice.

Pour ne pas subir les défauts provoqués par l'utilisation de contacts substrat rapprochés, l'exemple cherche à minimiser le nombre de contacts substrat rapprochés selon l'état de la technique et éventuellement à ne pas utiliser de contacts substrat rapprochés.

En lieu et place des contacts substrat rapprochés, l'exemple propose l'insertion, dans le substrat 51, entre au moins une première colonne Ck et une deuxième colonne Cl voisines, et/ou entre deux lignes voisines de diodes de la matrice, d'une ligne conductrice enterrée 53. Celle-ci a au moins une extrémité qui est reliée électriquement au contact substrat périphérique 55. Dans l'exemple de la figure 5A, elle est reliée par une de ses extrémités à la branche de contact 55.2. Elle est de plus sans contact électrique direct avec une quelconque diode Di de la matrice 50, ni au niveau des contacts diode 51, ni au niveau des zones dopées mentionnées plus haut.

La ligne conductrice enterrée 53 est disposée dans le substrat 51. Elle peut affleurer la surface principale du substrat 51. Ladite surface principale peut être une interface entre le substrat 51 et une couche supérieure, par exemple en matériau diélectrique. Les contacts diode mentionnés plus haut sont positionnés au niveau de ladite surface ou interface principale.

Alternativement la ligne conductrice enterrée 53 peut être enterrée dans le substrat 51, c'est-à-dire peut ne pas être située au niveau de la surface principale ou de l'interface principale décrites précédemment. La ligne conductrice enterrée 53 est alors séparée de la surface ou interface principale par une épaisseur donnée de matériau du substrat. Dans les deux cas précités, la surface peut être une interface entre le substrat 51 et une couche diélectrique qui sera illustrée plus loin en relation avec la figure 5B. Etant reliée au contact substrat périphérique 55, la ligne conductrice enterrée 53 peut agir comme une prolongation du contact substrat périphérique 55.

Si la ligne enterrée conductrice 53 est positionnée entre deux colonnes voisines, respectivement deux lignes voisines, elle a une longueur mesurée selon une direction principale d'une colonne, respectivement d'une ligne.

Chaque diode Di de la matrice est dite à une distance inter-contacts enterrée L7i de la ligne conductrice enterrée 53. En particulier, sur la figure 5A, deux diodes quelconques $Di_2$, $Di_3$ sont référencées. Elles sont respectivement à une distance inter-contacts de bordure $L5i_2$, $L5i_3$ du contact substrat 55 et à une distance inter-contacts enterrée $L7i_2$, $L7i_3$ de la ligne conductrice enterrée 53.

La figure 5B est une coupe de la figure 5A selon un axe AA', coupant plusieurs diodes Di de la matrice 50 appartenant à une même ligne. Chaque diode Di comporte au moins une deuxième zone dopée 52i dans le substrat 51 tel que décrit plus haut en relation avec la figure 2. Par esprit de simplification, on appellera la deuxième zone dopée « zone dopée 52i» dans la suite de la description.

Le substrat est en un matériau semi-conducteur. Le substrat 51 peut être en Si, en SiGe, en $Hg_{1-x}Cd_x$-Te, en GaAs, en InP, en SiC ou en semi-conducteur sur isolant (SOI) ou en tout autre matériau semi-conducteur connu de l'homme du métier pour permettre une fabrication de diodes et en particulier de diodes à propriétés optiques.

Chaque diode Di comporte, de plus, un contact diode 54i constitué d'un pied 57i situé à l'intérieur de la zone dopée 52i et d'une tête 58i située en surface du substrat 51. La tête 58i est généralement recouverte d'une couche diélectrique 59, de façon à supporter des liaisons électriques et des interconnexions non représentées reliant les diodes Di à un circuit électronique extérieur non représenté.

Sur la figure 5B est illustrée une coupe de la branche de contact 55.1 du contact substrat périphérique 55, dont au moins une partie pénètre dans le substrat 51. Il est de plus représenté des coupes de quatre diodes, dont la diode référencée $Di_2$, et une coupe de la ligne conductrice enterrée 53. La ligne conductrice enterrée 53 a une épaisseur H mesurée selon un axe sensiblement perpendiculaire à un plan défini par les diodes Di. La ligne conductrice enterrée 53 a de plus une largeur T mesurée de façon sensiblement perpendiculaire à l'épaisseur H et à la longueur .

Chaque contact diode 54i est tel qu'il existe une distance inter-contacts de bordure L5i entre le pied 57i du contact diode 54i et le contact substrat périphérique 55, ici la branche de contact 55.1. De plus, le pied 57i de chaque contact diode 54i est à une distance inter-contacts enterrée L7i de la ligne conductrice enterrée 53.

Selon l'exemple, la ligne conductrice enterrée 53 est séparée au minimum par une distance minimale W" de toute zone dopée 52i des diodes Di. Une distance minimale W" trop faible pourrait conduire à former des courants de fuite entre la zone dopée 52i et la ligne conductrice enterrée 53. Des valeurs de W" sont données plus loin à titre d'exemple.

La largeur T et l'épaisseur H sont de préférence telles que de la ligne conductrice enterrée 53 ne perturbe pas la périodicité de l'agencement des diodes Di. Il est alors possible d'intercaler la ligne conductrice enterrée 53 entre deux lignes ou deux colonnes de la matrice, dans un espace présent de façon usuelle entre deux diodes voisines, sans modifier le pas pixel P de la matrice. L'épaisseur T et la hauteur H de la ligne conductrice enterrée 53 sont de plus adaptées pour que la ligne conductrice enterrée occupe un volume le plus important possible dans l'espace présent de façon usuelle entre deux diodes voisines sans pour autant former des courants de fuite avec les diodes. Plus les lignes conductrices enterrées auront une section importante, plus leur résistance sera faible. De plus, tel qu'il le sera énoncé plus bas, plus la ligne conductrice enterrée 53 aura une section importante, plus elle stabilisera l'interface entre le substrat 51 et la couche diélectrique 59.

La largeur T et l'épaisseur H de la ligne conductrice enterrée 53 dépendent de la technologie utilisée pour fabriquer la matrice de diodes Di. Il va être donné en exemple de valeurs de dimensions dans le cadre d'une technologie dite « pas pixel 15 $\mu$m », dans laquelle le pas pixel ou pas majoritaire de la matrice est proche de 15 $\mu$m aussi bien pour les lignes que pour les colonnes :

La largeur T de la ligne conductrice enterrée 53 peut être comprise entre 0,5 $\mu$m et 5 $\mu$m, par exemple 1

μm ou 2 μm.

L'épaisseur H de la ligne conductrice enterrée 53 est approximativement du même ordre de grandeur que sa largeur T, par exemple comprise entre 0,5 μm et 2 μm.

De plus, dans une technologie « pas pixel 15 μm » les diodes Di peuvent avoir une tête 58i de contact diode dont la surface est de 10x10 μm², la zone dopée 52i peut avoir une surface, dans un plan parallèle à une surface principale du substrat, proche de 12x12 μm².

Si les diodes ont des dimensions différentes, soit en raison de l'utilisation d'une autre technologie de la microélectronique, soit en raison d'une application différentes pour les diodes, les dimensions de la ligne conductrice enterrée 53 sont alors adaptées.

Dans une variante préférentielle, la ligne conductrice enterrée 53 est une autre zone dopée dans le substrat. Elle est composée du ou des mêmes éléments chimiques du matériau semi-conducteur du substrat 51, mais ce matériau est dopé différemment. La ligne conductrice enterrée 53 est alors principalement différenciée du substrat 51 en ce qu'elle comporte un dopant de ligne ayant une densité de dopage importante, supérieure de plusieurs ordres de grandeur au dopage présent dans le matériau du substrat 51. La ligne conductrice enterrée 53 est alors définie comme étant dans un volume contenant le dopant de ligne, ce volume étant relié au contact substrat périphérique 51.

La densité du dopant de ligne dans le matériau semi-conducteur formant la ligne conductrice enterrée est typiquement comprise entre $10^{15}$ et $10^{20}$ at/cm³. A titre de comparaison, le substrat 51, hormis les zones dopées 52i des diodes Di, a une densité typiquement comprise entre $10^{14}$ et $10^{17}$ at/cm³.

Si le dopant de ligne est de type accepteur, il est obtenu un dopage de type p+. Si le dopant de ligne est de type donneur, il est obtenu un dopage de type n+.

Dans certaines situations, le dopant de ligne peut être présent avec une telle densité, par exemple supérieure à $10^{18}$ at/cm³, que le matériau de la ligne conductrice enterrée 53 devient dégénéré. Cela signifie que le matériau du substrat 51, initialement semi-conducteur, acquiert, dans le volume définissant la ligne conductrice enterrée 53, un comportement métallique à cause de la présence du dopant. En pratique, le matériau de la ligne conductrice enterrée 53 a alors une conductivité et une mobilité ayant un même ordre de grandeur que celles des métaux utilisés usuellement en microélectronique.

Dans d'autres situations, la densité de dopant dans la ligne conductrice enterrée 53 est insuffisante pour avoir un matériau semi-conducteur dégénéré dans la ligne conductrice enterrée 53.

On définira dans la suite de la description une demi-longueur de la ligne conductrice enterrée comme étant une distance entre la diode la plus éloignée possible de toute partie d'un contact substrat périphérique (ou contact substrat rapproché) et ledit contact substrat, mesurée en suivant un axe sur lequel peut se trouver une ligne conductrice enterrée 53. S'il y a deux branches de contact positionnées sur des côtés opposés de la matrice, la demi-longueur sera sensiblement égale à la moitié de la distance séparant ces deux branches de contact. Si de plus certaines lignes conductrices enterrées 53 relient ces deux branches de contact opposées, la demi-longueur est sensiblement égale à la moitié de la longueur de ladite ligne conductrice enterrée 53. De façon alternative, si toutes les branches de contact n'ont pas une branche de contact située d'un côté opposé de la matrice, certaines lignes conductrices enterrées 53 ne sont reliées aux branches de contact que par une seule extrémité. La demi-longueur est alors sensiblement égale à la longueur de ces lignes conductrices enterrées 53.

Pour la suite de la description, nous définirons, pour les lignes conductrices enterrées, trois catégories de conductivité.

Il sera dit que la ligne conductrice enterrée 53 a une conductivité suffisante de première catégorie, dite première conductivité, si elle a une résistance, mesurée pour une demi-longueur de ligne conductrice enterrée 53, négligeable devant la résistance critique, par exemple plus faible d'un facteur supérieur à 2 ou à 5 ou à 10.

Les lignes conductrices enterrées composées d'un matériau semi-conducteur dégénéré seront souvent considérées comme ayant une première conductivité. Cela peut ne pas être vrai si la section desdites lignes conductrices enterrées est trop faible.

On dira que la ligne conductrice enterrée 53 a une conductivité acceptable de deuxième catégorie, dite seconde conductivité, si sa résistance, mesurée dans les conditions définies ci-dessus, est inférieure à la résistance critique. Une ligne conductrice enterrée 53 ayant une première conductivité a *a-fortiori,* une conductivité supérieure à la seconde conductivité.

Autrement, il sera dit que la ligne conductrice enterrée a une conductivité insuffisante. Dans certaines situations, une ligne conductrice enterrée 53 composée d'un matériau semi-conducteur dopé non dégénéré peut avoir une seconde conductivité ou une conductivité insuffisante. Ce dernier cas sera traité plus loin dans la description.

Avantageusement, le matériau de la ligne conductrice enterrée 53 se différencie de la zone dopée 52i en ce que le dopant de ligne et celui de la zone dopée 52i sont de types différents. Ainsi, selon que la zone dopée 52i comporte un dopant de type p ou un dopant de type n, de façon avantageuse, la ligne conductrice enterrée 53 comportera un dopant de ligne induisant respectivement un dopage de type n ou un dopage de type p.

En particulier, si le matériau du substrat est de type HgCdTe, ou $Hg_{1-x}Cd_xTe$, dans le cas de diodes p/n, comportant une zone dopée 52i comportant un dopant de type p, le dopant de ligne présent dans la ligne conductrice enterrée 53 peut être de type n tel que de l'indium ou le bore. Inversement, en conservant le même matériau pour le substrat, dans le cas de diodes n/p, comportant une zone dopée 52i comportant un dopant de type n, le dopant de ligne peut être de type p tel que de l'arsenic.

Si la ligne conductrice enterrée 53 a une première conductivité, et qu'elle est formée d'un matériau semi-conducteur dégénéré, il est considéré qu'elle est assimilable à une branche du contact substrat périphérique 55 mais située entre deux lignes voisines et/ou deux colonnes voisines de la matrice 50. Il est en effet considéré que la ligne conductrice enterrée 53 n'a aucune influence sur la résistance parasite perçue par les diodes Di. Autrement dit, la résistance de la ligne conductrice enterrée 53 est considérée comme négligeable. Alors, si, pour une diode Di, la distance inter-contacts interne L7i est inférieure à la distance inter-contacts critique, la résistance parasite perçue par ladite diode Di est inférieure à la résistance critique. Il ne peut être estimé un gain sur les dimensions de la matrice de diodes rendu possible par l'utilisation de telles lignes conductrices enterrées 53 par rapport à l'état de la technique. En effet, pour des lignes conductrices enterrées ayant une première conductivité, une matrice de diode peut avoir toute taille désirée.

Il y a cependant une résistance parasite associée à chaque diode Di, liée au premier ordre à une plus petite distance parmi la distance inter-contacts de bordure L5i et la distance inter-contacts enterrée L7i.

Si la ligne conductrice enterrée 53 n'a pas une conductivité suffisamment élevée, il ne peut être considéré que la ligne conductrice enterrée 53 est assimilable à une branche du contact substrat 55. Alors, pour savoir si une diode Di perçoit une résistance parasite inférieure à la résistance critique, il faut prendre en compte la résistance parasite due au substrat et celle due à la ligne conductrice enterrée. La résistance parasite due au substrat est mesurée en fonction de la plus petite distance entre la distance inter-contacts de bordure L5i et la distance inter-contacts enterrée L7i. La résistance de la ligne conductrice enterrée 53 est mesurée sur une longueur utile de la ligne conductrice enterrée 53, c'est-à-dire entre le contact substrat périphérique 55 et un point de la ligne conductrice enterrée 53 situé le plus proche possible de la diode Di.

Cependant, que la ligne conductrice enterrée 53 ait une première conductivité, une seconde conductivité ou une conductivité insuffisante, sa conductivité reste largement supérieure à une conductivité caractéristique du matériau du substrat.

La résistance parasite de bordure R1 entre un contact diode d'une diode donnée et le contact substrat périphérique 55 est définie par la relation {1} suivante :

$$R1 \approx \frac{L5}{\mu \times \Delta \times E \times l}$$

Avec $\mu$ une mobilité des porteurs initiale dans le substrat, L5 la distance inter-contacts de bordure liée à la diode donnée, $\Delta$ une densité de dopage dans le substrat, E une épaisseur du substrat et I une largeur caractéristique du contact diode et assimilable au premier ordre à un pas pixel.

De façon à ce qu'une diode puisse fonctionner de manière acceptable, il est nécessaire selon l'état de la technique que la résistance parasite soit inférieure à la résistance critique. La résistance critique est mesurée lorsqu'un courant parcourt le substrat sur la distance inter-contacts critique définie plus haut.

Alors, de la même façon il est possible de calculer une valeur de la résistance parasite $R_{ligne}$ induite par la ligne conductrice enterrée 53. Selon la relation {2} ci-dessous, la résistance parasite $R_{ligne}$ due à la ligne dépend de la longueur utile $L_{utile}$ définie plus haut.

$$R_{ligne} \approx \frac{L_{utile}}{\mu \times \Delta_{ligne} \times H \times T}$$

La résistance parasite $R_{ligne}$ dépend, de plus, de la largeur T et de l'épaisseur H de la ligne conductrice enterrée 53 ainsi que de la densité de dopage $\Delta_{ligne}$ dans la ligne conductrice enterrée 53.

A la résistance parasite liée à la ligne conductrice enterrée 53, il est nécessaire d'ajouter, à la résistance parasite, une composante de résistance parasite secondaire. Celle-ci est liée à une portion de substrat 51 séparant la diode étudiée de la ligne conductrice enterrée 53. Cette résistance parasite secondaire est calculée de manière similaire à la relation {1}, la distance inter-contacts de bordure L5i étant remplacée par la distance inter-contacts interne L7i.

Si la ligne conductrice enterrée est à proximité immédiate de la diode étudiée, c'est-à-dire positionnée entre la diode étudiée et une diode voisine, la résistance parasite secondaire est négligeable. Ayant une conductivité plus importante que le matériau du substrat 51, la ligne conductrice enterrée 53 a une résistance parasite $R_{ligne}$ plus faible que la résistance parasite de bordure R1 exprimée par la relation {1}. Ces deux résistances, R1, $R_{ligne}$ étant en parallèle l'une de l'autre, il s'ensuit que la diode Di étudiée est reliée au contact substrat périphérique 55 par un canal de conduction privilégié via la ligne conductrice enterrée 53.

Ainsi, la ligne conductrice enterrée 53 permet de réduire la résistance parasite entre la diode étudiée et le contact substrat et ainsi réduit virtuellement la distance inter-contacts de bordure.

Il est donc possible de calculer un gain en résistance obtenu par l'utilisation d'une ligne conductrice enterrée 53 située à proximité immédiate d'une diode Di.

La relation {3} ci-dessous permet d'exprimer le gain G en fonction des paramètres décrits précédemment. Il sera considéré que la ligne conductrice enterrée 53 étant située à proximité immédiate d'une diode, la distance inter-contact de bordure L5 et la longueur utile

$L_{utile}$ de la ligne conductrice enterrée sont sensiblement identiques.

$$G = \frac{R_{ligne}}{R} = \frac{\Delta}{\Delta_{ligne}} * \frac{E}{H} * \frac{l}{T} * \frac{\mu}{\mu_{ligne}} * \frac{L_{utile}}{L}$$

Aux fins de ce calcul, il sera pris des exemples particuliers de dimensions pour le contact diode 54i et la ligne conductrice enterrée 53. Ces exemples particuliers sont dépendants de la technologie utilisée pour fabriquer les diodes, ici la technologie « pas pixel 15 μm », et de l'application visée pour les diodes.

Il est considéré, aux fins du calcul, que la ligne conductrice enterrée a une largeur T de l'ordre de 3 μm et une épaisseur H d'environs 2 μm. Le pas pixel considéré est de 15 μm et l'épaisseur E du substrat est approximativement de 10 μm. De plus, la mobilité dans le substrat a pu être mesurée comme étant sensiblement égale à 400 cm²/V.s tandis que la mobilité dans la ligne conductrice enterrée a une valeur avoisinant 200 cm²/V.s. La densité de dopant dans le substrat est proche de $1.10^{16}$ at/cm³. En comparaison, dans l'exemple étudié, la densité de dopant dans la ligne conductrice enterrée peut être de l'ordre de $1.10^{18}$ at/cm³.

Le gain G, calculé au moyen de la relation {3}, a alors une valeur comprise entre 2 et 100. La présence d'une ligne conductrice enterrée 53 à proximité immédiate d'une diode Di induit une réduction virtuelle de la distance inter-contacts de bordure d'un facteur compris entre 2 et 100. Chaque diode, située à une distance donnée du contact substrat périphérique 55, perçoit en effet une résistance parasite 2 à 100 fois plus faible lorsqu'elle est située à proximité immédiate d'une ligne conductrice enterrée que celle qu'elle perçoit, selon la relation {1}, lorsqu'un courant parcourt le substrat sur la même distance et qu'il n'y a pas de ligne conductrice enterrée.

Si la ligne conductrice enterrée a une seconde conductivité telle que décrite ci-avant, la résistance de la ligne conductrice enterrée mesurée sur la demi-longueur est inférieure à la résistance critique. Alors, en positionnant au moins une ligne conductrice enterrée 53 à proximité immédiate de toute diode Di, il est possible de concevoir une matrice ne comportant pas de contacts substrat rapprochés et de dimensions 2 à 100 fois supérieures à celles de l'état de la technique. De façon avantageuse, pour cette méthode, la ligne conductrice enterrée est reliée électriquement au contact substrat périphérique en ses deux extrémités.

Si l'on désire obtenir une matrice encore plus grande, il peut être envisagé d'augmenter la densité de dopage dans les lignes conductrices enterrées 53 de façon à augmenter le gain G et ainsi avoir une réduction virtuelle de la distance inter-contacts plus importante. De façon alternative, il peut être envisagé d'utiliser des lignes conductrices enterrées 53 en matériau semi-conducteur dégénéré. Elles ont alors une première conductivité telle que décrite ci-avant et sont assimilables à des branches du contact substrat périphérique, situées au cœur de la matrice.

Enfin, il est possible d'introduire des contacts substrat rapprochés dans la matrice 50 comme il le sera décrit plus loin. Ceci est particulièrement utile si les lignes conductrices enterrées ont une conductivité insuffisante telle que décrite ci-avant ou si elles ont une seconde conductivité telle que décrite ci-avant mais qu'il existe des diodes qui ne sont pas situées à proximité immédiate des lignes conductrices enterrées. Cependant, en utilisant des lignes conductrices enterrées 53, chaque diode peut être située à une distance inter-contacts interne dudit contact substrat rapproché supérieure à celle de l'état de la technique.

L'état de la technique permet de fabriquer une matrice de diodes telle que chaque diode soit éloignée d'un contact substrat périphérique ou d'un contact substrat rapproché d'une distance inférieure à la distance inter-contacts critique.

En induisant une réduction virtuelle des distances inter-contacts par un facteur 2 à 100, les lignes conductrices enterrées permettent d'obtenir une matrice de mêmes dimensions que dans l'état de la technique tout en introduisant de 2 à 2500 fois moins de contacts substrat rapprochés que selon l'état de la technique. Dans certains cas, si en introduisant 2 à 2500 fois moins de contacts rapprochés que selon l'état de la technique, on obtient un nombre théorique de contacts rapprochés inférieur à 1, on peut supprimer complètement les contacts substrat rapprochés dans la matrice. Une telle situation est déjà décrite plus haut en lien lorsque les lignes conductrices enterrées ont une seconde conductivité telle que décrite ci-avant.

Il est possible de placer une ligne conductrice enterrée 53 entre deux lignes voisines et/ou entre deux colonnes voisines. Il est de plus possible de prévoir plusieurs lignes conductrices enterrées 53, chacune comprise entre deux lignes voisines et/ou deux colonnes voisines. S'il y a à la fois une ligne conductrice enterrée entre deux lignes voisines et une ligne conductrice enterrée entre deux colonnes voisines, les deux lignes conductrices enterrées se croisent en une intersection et forment un maillage de lignes conductrices enterrées.

En pratique, il peut y avoir autant de lignes conductrices enterrées, présentes chacune entre deux lignes voisines et ou deux colonnes de la matrice voisines, qu'il l'est nécessaire pour que chaque diode de la matrice soit reliée à un contact substrat, périphérique ou rapproché, via une résistance parasite inférieure à la résistance critique, c'est-à-dire négligeable pour un fonctionnement acceptable de la diode.

Si les lignes conductrices enterrées 53 ont une première conductivité telle que décrite ci-avant, en matériau semi-conducteur dégénéré, elles sont disposées dans la matrice de telle sorte que chaque diode Di est à une distance d'au moins une branche du contact substrat périphérique 55 ou d'au moins une ligne conductrice enterrée 53 inférieure à la distance inter-contacts critique.

Si les lignes conductrices enterrées 53 n'ont pas une première conductivité telle que décrite ci-avant, elles sont disposées dans la matrice 50 de telle sorte que chaque diode Di soit à une distance virtuelle d'au moins une branche du contact substrat périphérique 55, ou d'au moins un contact substrat rapproché, inférieure à la distance inter-contacts critique. Cette distance virtuelle prend en compte l'effet de réduction virtuelle des distances inter-contacts permis par les lignes conductrices enterrées 53 et énoncé plus haut.

De préférence, si la matrice est formée de lignes ayant une première longueur et de colonne ayant une deuxième longueur, la ou les lignes conductrices enterrées 53 situées entre deux lignes voisines ont une longueur supérieure ou égale à la première longueur et la ou les lignes conductrices enterrées 53 présentes entre deux colonnes voisines ont une longueur supérieure ou égale à la seconde longueur. En effet, si le contact substrat 55 comporte quatre branches de contact, agencées deux par deux le long de côtés opposés de la matrice 50, il est préférable que la ou les lignes conductrices enterrées 53 soient reliées électriquement aux deux branches de contact situées sur des côtés opposés de la matrice 50.

Un dispositif selon l'invention comporte une ligne conductrice enterrée entre deux colonnes voisines de diodes et lignes voisines de diodes toutes les k colonnes et/ou toutes les m lignes de la matrice, de façon périodique. Dans la suite de la description, un deuxième, un troisième et un quatrième mode de réalisation vont être présentés illustrant ceci. Dans ces différents modes de réalisation les valeurs de k et m sont égales entre elles et valent respectivement 30, 2 et 1. Il est bien entendu possible que k et m aient des valeurs différentes. C'est en particulier le cas si le pas de ligne et le pas de colonne ont des valeurs différentes.

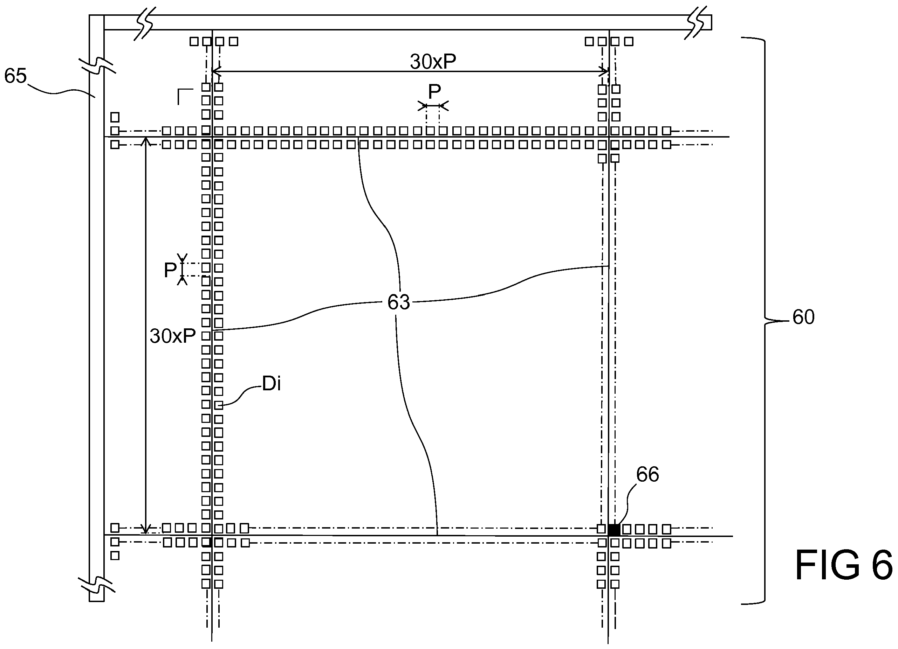

Selon un deuxième mode de réalisation qui ne fait pas partie de l'invention, décrit en figure 6, il y a dans une matrice 60, une ligne enterrée 63 entre deux lignes voisines et/ou entre deux colonnes voisines toutes les 30 lignes ou 30 colonnes de la matrice.

Le mode de réalisation de la figure 6 ne fait pas partie de l'invention, à strictement parler, puisque la figure 6 ne montre pas un maillage complet. Pour autant, la description relative à la figure 6 s'applique de la même manière à l'invention.

La distance inter-contacts critique peut, en tenant compte d'une marge de sécurité, être estimée à une valeur proche de quinze fois une valeur du pas pixel P dans le cadre de la technologie pas pixel 15 μm. Alors, selon l'état de la technique, on positionnait un contact substrat rapproché toutes les 20 lignes et 20 colonnes pour que toutes les diodes soit à une distance inter-contacts interne inférieure à la distance inter-contacts critique.

Dans ce mode de réalisation, chaque diode Di de la matrice 60 est au plus à une distance de 15 pas pixel d'une ligne conductrice enterrée 63. Ainsi, chaque diode est à une distance inter-contacts enterrée d'une ligne conductrice enterrée 63 inférieure à la distance inter-contacts critique.

Ce mode de réalisation, illustré en figure 6, est avantageux si les lignes conductrices enterrées 63 ont une première conductivité telle que décrite ci-avant, en particulier si elles sont ou en matériau semi-conducteur dégénéré. En effet, toute résistance induite par la ligne conductrice enterrée 63 étant alors négligée, chaque diode Di perçoit une résistance parasite inférieure à la résistance critique. Il est alors possible de se passer de contacts substrat rapprochés.

Si les lignes conductrices enterrées 63 ne sont pas en matériau semi-conducteur dégénéré, il faut veiller à ce que la conductivité des lignes conductrices enterrées 63 soit suffisante pour contribuer de façon négligeable à la résistance parasite perçue par une diode la plus éloignée possible de toute ligne conductrice enterrée 63. Il va donc falloir adapter la densité de dopage pour faire varier la conductivité en fonction de la longueur λ de la ligne conductrice enterrée 63 et en fonction des dimensions de la matrice 60. En variante, on peut rapprocher les lignes conductrices enterrées de façon à ce que la distance inter-contacts enterrée soit réduite en tenant compte de la résistance parasite induite par les lignes conductrices enterrées. Cela permet alors d'utiliser des lignes conductrices enterrées n'ayant pas une première conductivité telle que décrite ci-avant mais qui contribuent à la résistance parasite.

En variante, dans le cas où les lignes conductrices enterrées 63 ont une conductivité insuffisante au sens décrit ci-avant ou une seconde conductivité, il peut être ajouté un ou plusieurs contacts substrat rapprochés 66 dans la matrice. Les contacts substrat rapprochés 66 sont situés dans la matrice de façon à être en contact électrique direct avec au moins une ligne conductrice enterrée 63 et de préférence avec deux lignes conductrices enterrées 63 à la fois. Par exemple les contacts substrat 66 rapprochés peuvent être au niveau d'une intersection de deux lignes conductrices enterrées 63.

Dans cette figure 6 il a été représenté un contact substrat rapproché 66, intégré dans la matrice en substitution d'une diode Di au niveau d'une intersection de deux lignes conductrices enterrées 63 et en contact électrique avec ces deux lignes conductrices enterrées 63. De façon alternative et non représentée, le contact substrat rapproché peut être inséré entre deux lignes voisines et/ou deux colonnes voisines, donnant entre ces deux lignes voisines et/ou colonnes voisines un pas étendu supérieur au pas majoritaire de ligne ou de colonne.

On décrit ensuite un troisième et un quatrième modes de réalisation, qui ne se rapportent pas à l'invention à strictement parler, puisqu'il n'y est pas précisé que les lignes conductrices enterrées ont un gap supérieur à celui du substrat. Pour autant, la description relative à ces deux modes de réalisation s'applique de la même manière à l'invention.

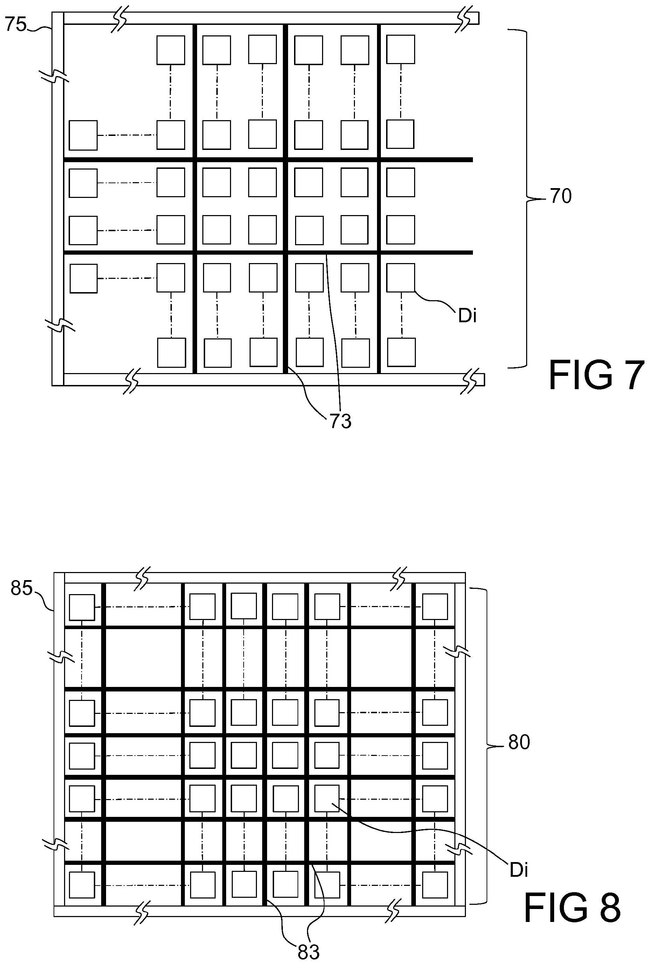

Selon le troisième mode de réalisation qui ne fait pas partie de l'invention, illustré en figure 7, il y a dans la matrice 70 une ligne enterrée 73 s'étendant entre deux lignes voisines et/ou entre deux colonnes voisines toutes les deux lignes et/ou deux colonnes de la matrice. De plus, dans cette figure il a été représenté trois branches pour le contact substrat périphérique 75. Deux des branches de contact sont situées sur des côtés opposés de la matrice 70. Certaines lignes conductrices enterrées 73 sont simultanément reliées électriquement à ces deux branches de contact opposées.

Une différence de potentiel appliquée entre les contacts diode des différentes diodes Di et un contact substrat périphérique 75 présent en bord de matrice devient assimilable à une différence de potentiel appliquée entre les contacts diode et les lignes conductrices enterrées 73 voisines.

Puisqu'on prévoit une ligne conductrice enterrée 73 entre deux lignes ou entre deux colonnes toutes les deux lignes et toutes les deux colonnes de la matrice, alors, les diodes Di sont encadrées quatre par quatre par des lignes conductrices enterrées 73. Chaque diode Di de la matrice perçoit donc un champ électrique sensiblement identique issu des lignes conductrices enterrées 73, variant uniquement par une rotation de 90°.

Cette situation permet de plus d'avoir une résistance parasite minimale si l'on considère que les lignes conductrices enterrées 73 n'apportent pas de contribution à la résistance parasite, c'est-à-dire si elles ont une première conductivité telle que décrite ci-avant, par exemple si elles sont en matériau semi-conducteur dégénéré.

Dans le quatrième mode de réalisation qui ne fait pas partie de l'invention, illustré en figure 8, il y a dans une matrice de diodes 80 une ligne conductrice enterrée 83 entre chaque ligne et entre chaque colonne de la matrice. Les valeurs de k et m sont alors respectivement égales à un.

De plus, dans cette figure il a été représenté quatre branches de contact pour le contact substrat périphérique 85. Les branches de contact sont situées en bordure de la matrice 80 et sont arrangées deux à deux de façon à border quatre côtés de la matrice, opposés deux à deux. Toutes les lignes conductrices enterrées 73 ont leurs deux extrémités reliées chacune à une branches de contact. Ces dites branches de contact sont situées sur des côtés opposées de la matrice.

Si l'on considère que les lignes conductrices enterrées n'apportent pas de contribution à la résistance parasite, cette situation ne permet pas d'avoir une résistance parasite plus faible que dans le mode de réalisation précédent.

Cependant, si les lignes conductrices enterrées 83 apportent une contribution aux résistances parasites, ce mode de réalisation permet de réduire la résistance parasite associée à chaque diode Di par rapport aux deux modes de réalisation précités. En effet, dans ce mode de réalisation, chaque diode Di est reliée par quatre lignes conductrices enterrées 83, chacune en contact électrique avec au moins une branche de contact située en périphérie de la matrice. A titre de comparaison, dans le mode de réalisation précédent, chaque diode Di n'est reliée aux branches de contact que par deux lignes conductrices enterrées.

Si les lignes conductrices enterrées n'ont pas une première conductivité telle que décrite ci-avant, il sera préféré un agencement des lignes conductrices enterrées 73, 83 selon le troisième ou le quatrième mode de réalisation, illustrés respectivement en figures 7 et 8. Dans ces deux modes de réalisation, chaque diode Di considérée est à proximité immédiate d'au moins une ligne conductrice enterrée 73, 83. C'est-à-dire qu'au moins une ligne conductrice enterrée s'étend entre ladite diode Di et au moins une diode voisine. En particulier, dans ces deux modes de réalisation, il est possible d'avoir deux lignes conductrices enterrées ou plus, situées à proximité immédiate de chaque diode.

Dans le cas du quatrième mode de réalisation, illustré en figure 8, chaque diode Di est à proximité immédiate de quatre lignes conductrices enterrées 83.

Ces deux modes de réalisation permettent donc d'obtenir un gain plus important par rapport à celui calculé à partir de l'expression {3}. En particulier, dans le quatrième mode de réalisation toutes les branches du contact substrat périphérique 85 sont reliées à deux lignes conductrices enterrées situées à proximité immédiate de chaque diode de la matrice, une ligne conductrice enterrée étant placée de part et d'autre de ladite diode. Ainsi, pour chaque diode, le quatrième mode de réalisation est équivalent à former un maillage de lignes conductrices enterrées 83 selon le troisième mode de réalisation mais avec une largeur T deux fois plus importante. Il y a donc un gain effectif G' plus important d'un facteur 2 à 4 que le gain G calculé strictement selon la relation {3} dans le cas où il y a une seule ligne conductrice enterrée qui s'étend à proximité immédiate d'une diode.

De plus, de façon indépendante de la densité en dopant utilisée dans les lignes conductrices enterrées, les troisième et quatrième modes de réalisation permettent une stabilisation accrue de l'interface entre le substrat et la couche diélectrique superposée au substrat. Dans la suite de la description il sera utilisé les références de la figure 5B, appliquée à un cas où il y a plusieurs lignes conductrices enterrées 53.

Tel que présenté plus haut, la présence des zones dopées 52i des différentes diodes Di, proche de l'interface entre le substrat 51 et la couche diélectrique 59 superposée au substrat, forme des effets de charge importants au niveau de cette interface.

Lorsque les lignes conductrices enterrées 53 sont proches de cette interface et ont une densité de dopage importante, du même ordre de grandeur que la densité de dopage dans les zones dopées des diodes, ou d'un ordre de grandeur supérieur, on forme une barrière de potentiel au niveau de l'interface entre le substrat et la couche diélectrique 59. Ceci est le cas pour toute ligne conductrice enterrée 53 selon l'invention composée de matériau semi-conducteur dopé, dégénéré ou non. Il y a donc une diminution d'interactions entre des porteurs minoritaires et des états recombinant, ce qui est une cause de déstabilisation de l'interface.

De plus, comme annoncé précédemment, les lignes conductrices enterrées 53 et la zone dopée 52i des diodes Di ont de préférence des dopages de type opposé. Alors, les lignes conductrices enterrées 53 induisent un équilibrage des charges au niveau de l'interface entre le substrat 51 et la couche diélectrique 59.

Ces deux points conduisent à une stabilisation de l'interface et un écrantage des effets de charge. Cela permet d'obtenir des bruits spatiaux, des bruits temporels et des bruits de cyclage réduits par rapport à une matrice selon l'état de la technique.

Dans le cas de lignes conductrices enterrées 53 à base de matériau semi-conducteur dopé avec un dopant de ligne, plus la largeur T et l'épaisseur H de la ligne conductrice enterrée 53 seront importantes, plus les effets d'écrantage et d'équilibrage des charges seront importants. En effet, le dopant de ligne a une présence au niveau de l'interface qui dépend des dimensions de la ligne conductrice enterrée 53 ainsi que du nombre de lignes conductrices enterrées 53 entourant chaque diode Di.

Dans un cas particulier de réalisation de l'invention, si le substrat est un matériau semi-conducteur à base de $Hg_{1-x}Cd_xTe$ ayant un gap donné et une première composition x en cadmium, il est avantageux que les lignes conductrices enterrées 53 soient dopées p+ avec un dopant de ligne de type accepteur, par exemple de l'arsenic. En effet, si le dopant présent dans la ligne conductrice enterrée 53 est de type accepteur, il est possible de former facilement une hétérostructure autopositionnée de composition dans laquelle les lignes conductrices enterrées 53 ont une seconde composition en cadmium supérieure à la première composition en cadmium. La surface du substrat ou l'interface entre le substrat et la couche diélectrique 58 reste alors à la première composition en cadmium.

Le gap dans un matériau en $Hg_{1-x}Cd_xTe$ dépend de la composition en cadmium. Ainsi, dans un dispositif tel que décrit ci-dessus, les lignes conductrices enterrées 53 sont dans un matériau ayant un plus grand gap que celui du substrat 51.

La formation dans les lignes conductrices enterrées 53 d'un gap plus important que celui du reste du substrat 51 permet de réduire les effets de charge en ajoutant une barrière de potentiel qui repousse les porteurs de l'interface.

Une matrice de diodes dont le substrat est en HgCdTe comporte généralement une couche de passivation, dont un des éléments est du cadmium Cd, située entre le substrat et la couche diélectrique.

Pour obtenir une hétérostructure auto-positionnée de composition, il doit y avoir une couche de passivation dont un des éléments est du cadmium Cd, (non représentée), déposée sur le substrat, en contact avec toute zone dopée p+ où l'on désire augmenter la composition en cadmium. Il est ensuite procédé à une étape de diffusion comprenant en particulier un recuit, par exemple avec une température supérieure à 100°C pendant une durée supérieure à une minute. Il y a alors diffusion sélective de cadmium, depuis la couche de passivation, dans toute zone du substrat 51 en contact avec la couche de passivation et comportant un dopage p+. La concentration en cadmium et le gap sont ainsi localement augmentés dans ces zones. Si seules les lignes conductrices enterrées sont dopées avec un dopage de type p+, la diffusion sélective est limitée à un volume défini par les lignes conductrices enterrées 53.

De préférence, lorsqu'il est formé une hétérostructure de composition dans les lignes conductrices enterrées 53, celles-ci sont dopées p+ et les zones dopées 52i des diodes Di sont dopées n ou n+ de façon à ce que seules les lignes conductrices enterrées aient un gap plus élevé que celui du substrat 51.

Si, alternativement, on désire des diodes Di dopées p sans hétérostructure de composition et des lignes conductrices enterrées ayant une hétérostructure autopositionnée de composition, il est possible de former la couche de passivation en CdTe uniquement au niveau des lignes conductrices enterrées 53, en contact avec celles-ci avant de procéder au recuit précité. Dit autrement, une couche de passivation est déposée sur tout le substrat sauf à l'aplomb des diodes Di de façon à ne pas former d'hétérostructure autopositionnée de composition au niveau des diodes Di. Il sera ensuite nécessaire de passiver les diodes et le restant du substrat avec une couche de passivation dont un des éléments est du cadmium Cd. Dans ce cas, le contact diode peut typiquement être fabriqué après la formation des hétérostructures dans les lignes conductrices enterrées 53.

Cependant, si l'on désire former une hétérostructure de composition dans les zones dopées 52i des diodes, il est possible d'utiliser des zones dopées 52i ayant un dopage p ou p+. Il est aussi possible, dans ce but, d'utiliser une matrice dans laquelle, les lignes conductrices enterrées 53i et les zones dopées 52i ont un même type de dopage. Alors, il y a un plus faible équilibrage des charges à l'interface entre le substrat et la couche diélectrique, les lignes conductrices enterrées 53 et les zones dopées 52i ayant un même type de dopage et de polarité.

Lorsqu'on utilise des lignes conductrices enterrées ayant une première conductivité telle que décrite ci-avant, il est généralement plus avantageux d'avoir des lignes conductrices enterrées 53 en matériau semi-conducteur dégénéré plutôt qu'en métal. En effet, des lignes conductrices enterrées 53 métalliques ne peuvent conduire à une augmentation locale du gap, ni à la formation d'une barrière de potentiel par équilibrage des charges à l'interface entre le substrat 51 et la couche diélectrique 59.

Il peut même être considéré comme étant plus avantageux d'avoir des lignes conductrices enterrées à base d'un matériau semi-conducteur dopé non dégénéré en lieu et place d'un ou plusieurs métaux. En effet, avoir un gain G plus faible mais obtenir une réduction de bruit important grâce à une meilleure stabilisation de l'interface peut être plus avantageux qu'obtenir un gain G plus important sur la résistance parasite mais une stabilisation de l'interface plus faible si l'on emploie des lignes conductrices enterrées 53 en métal.

Le dopant de ligne peut avoir été introduit par une implantation ionique, à une profondeur proche d'un centre désiré de la section de la ligne conductrice enterrée 53, suivie d'un recuit permettant une diffusion du dopant. Un exemple particulier est l'implantation d'arsenic à 500 KeV à une dose d'implantation de $2.10^{15}$ at/cm$^2$ suivie par un recuit à 400°C pendant 5 heures.

De manière alternative, le dopant de ligne peut avoir été introduit par diffusion du dopant dans le matériau du substrat 51. Cela peut par exemple être obtenu en déposant un masque en résine sur le substrat 51. Puis le masque en résine subit une photolithographie de façon à présenter des ouvertures là où l'on désire former des lignes conductrices enterrées.

Le dopant est apporté en contact avec le substrat à travers les ouvertures présentes dans le masque en résine. Ensuite un recuit de diffusion est effectué de façon à faire diffuser le dopant dans le substrat 51 et former les lignes conductrices enterrées 53.

Le dopant peut être apporté sous forme gazeuse ou sous forme solide. Si le dopant est présenté sous forme solide il peut s'agir d'une couche de matériau déposée par-dessus le masque en résine et dans les ouvertures. Un tel matériau est retiré suite au recuit de diffusion.

**Revendications**

**1.** Dispositif comportant un substrat en matériau semi-conducteur portant une matrice de diodes, organisées en lignes et en colonnes et un contact substrat périphérique agencé sur au moins un côté de la matrice, le substrat ayant un premier type de dopage et les diodes comportant dans le substrat une deuxième zone dopée ayant un deuxième type de dopage, opposé au premier type, le substrat étant en Si ou en SiC ou en SiGe ou étant un matériau à base de Hg$_{1-x}$Cd$_x$Te ou étant un substrat de type semi-conducteur sur isolant, SOI, le substrat comportant plusieurs autres zones dopées, chacune formant une ligne conductrice enterrée, chaque ligne conductrice enterrée affleurant une surface principale du substrat d'un côté où sont présentes les diodes, ou étant séparée de ladite surface principale par une épaisseur donnée du substrat, ces autres zones dopées ayant le premier type de dopage et une plus grande densité de dopage que dans le substrat, les lignes conductrices enterrées présentant un gap supérieur à celui du substrat lorsque les lignes conductrices enterrées sont en matériau semi-conducteur non dégénéré ou un gap effectif supérieur à celui du substrat lorsque les lignes conductrices enterrées sont en matériau semi-conducteur dégénéré, où le niveau de Fermi est situé dans une bande parmi la bande de conduction et la bande de valence et la position est fonction du dopage, où, lorsque le dopage est de type n+ avec le niveau de Fermi situé dans la bande de conduction, le gap effectif est la différence d'énergie entre le niveau de Fermi situé dans la bande de conduction et l'état correspondant à la transition directe dans la bande de valence qui au premier ordre est assimilée au haut de la bande de valence, et où, lorsque le dopage est de type p+, le gap effectif est assimilé au premier ordre au gap, les lignes conductrices enterrées étant électriquement reliées au contact substrat périphérique et positionnées entre deux colonnes voisines de diodes et entre deux lignes voisines de diodes et se croisant en une intersection de manière à former un maillage de lignes conductrices enterrées, **caractérisé en ce que** les lignes conductrices enterrées sont composées du ou des mêmes éléments chimiques que le matériau semi-conducteur du substrat et dopées avec un élément dopant, dit dopant de ligne présent avec une densité comprise entre $10^{15}$ et $10^{20}$ at/cm$^3$.

**2.** Dispositif selon la revendication 1, dans lequel les lignes conductrices enterrées sont én matériau semi-conducteur dégénéré.

**3.** Dispositif selon l'une des revendications 1 ou 2, dans lequel le substrat est en un matériau à base de Hg$_{1-x}$Cd$_x$Te et le dopant de ligne est de l'arsenic ou du bore en fonction du type de dopage voulu dans la ligne conductrice enterrée.

**4.** Dispositif selon l'une des revendications 1 à 3, dans lequel, le substrat est en un matériau à base de Hg$_{1-x}$Cd$_x$Te ayant, entre deux diodes voisines, une première composition en cadmium, et dans lequel les lignes conductrices enterrées ont un dopage de type « p » et ont une deuxième composition en cadmium plus élevée que la première composition.

**5.** Dispositif selon l'une des revendications 1 à 4, dans lequel les lignes conductrices enterrées sont dans le substrat et affleurent une surface principale du substrat d'un côté où sont présentes les diodes, ladite surface pouvant être une interface entre le substrat et une couche diélectrique recouvrant les diodes et le substrat.

**6.** Dispositif selon l'une des revendications 1 à 4, dans lequel les lignes conductrices enterrées sont enterrées dans le substrat du côté d'une surface principale du substrat où sont présentes les diodes, les lignes conductrices enterrées étant séparées de cette surface principale par une épaisseur donnée de matériau du substrat, ladite surface pouvant être une interface entre le substrat et une couche diélectrique recouvrant les diodes et le substrat.

7. Dispositif selon l'une des revendications 1 à 6, comportant une ligne conductrice enterrée entre deux colonnes voisines de diodes et/ou deux lignes voisines de diodes au moins toutes les k colonnes et/ou les m lignes de la matrice, k et m valant trente, deux ou un.

8. Dispositif selon l'une des revendications 1 à 7, dans lequel chaque ligne conductrice enterrée, présente entre deux lignes voisines ou entre deux colonnes voisines de longueurs données, a une longueur supérieure ou égale aux longueurs desdites colonnes ou desdites lignes.

9. Dispositif selon l'une des revendications 1 à 8, dans lequel les lignes conductrices enterrées ont, définies dans un plan contenant les diodes, une longueur et une largeur, la largeur étant perpendiculaire à la longueur et comprise entre environ 0,5 $\mu$m et 5 $\mu$m.

10. Dispositif selon l'une des revendications 1 à 9, dans lequel les lignes conductrices enterrées ont une épaisseur, définie sensiblement suivant une normale à un plan contenant les diodes, comprise entre environ 0,5 $\mu$m et 2 $\mu$m.

11. Dispositif selon l'une des revendications 1 à 10, dans lequel un ou plusieurs contacts substrat approchés sont présents, en contact électrique avec au moins une ligne conductrice enterrée et reliés électriquement au contact substrat périphérique par des liaisons électriques autres que les lignes conductrices enterrées, le ou les contacts substrat rapprochés pouvant être insérés entre deux lignes voisines et/ou colonnes voisines ou pouvant être en substitution d'une diode.

**Patentansprüche**

1. Vorrichtung, umfassend ein Substrat aus Halbleitermaterial, das eine Matrix von Dioden trägt, die in Zeilen und in Spalten organisiert sind, und einen Umfangssubstratkontakt, der auf wenigstens einer Seite der Matrix angeordnet ist, wobei das Substrat einen ersten Dotiertyp hat, und die Dioden in dem Substrat eine zweite dotierte Zone mit einem zweiten Dotiertyp entgegengesetzt zum ersten Typ umfassen, wobei das Substrat aus Si oder aus SiC oder aus SiGe ist, oder ein Material auf Basis von $Hg_{1-x}Cd_xTe$ ist, oder ein Substrat vom Typ Halbleiter auf Isolator, SOI, ist, wobei das Substrat mehrere andere dotierte Zonen umfasst, die jeweils eine vergrabene leitfähige Leitung bilden, wobei jede vergrabene leitfähige Leitung mit einer Hauptoberfläche des Substrats auf einer Seite fluchtet, wo die Dioden vorgesehen sind, oder von der Hauptoberfläche um eine gegebene Substratdicke getrennt ist,
wobei diese anderen dotierten Zonen den ersten Dotiertyp und eine größere Dotierdichte als im Substrat haben, wobei die vergrabenen leitfähigen Leitungen einen Gap größer als jener des Substrats aufweisen, wenn die vergrabenen leitfähigen Leitungen aus nicht-degeneriertem Halbleitermaterial sind, oder einen effektiven Gap größer als jener des Substrats, wenn die vergrabenen leitfähigen Leitungen aus einem degenerierten Halbleitermaterial sind, wo das Ferminiveau in einem Band aus dem Leitungsband und dem Valenzband liegt, und die Position eine Funktion der Dotierung ist, wobei dann, wenn die Dotierung vom Typ n+ ist und das Ferminiveau im Leitungsband liegt, der effektive Gap die Energiedifferenz zwischen dem im Leitungsband liegenden Ferminiveau und dem Zustand ist, der dem direkten Übergang in das Valenzband entspricht, der in erster Ordnung an die Oberkante des Valenzbands angeglichen ist, und wobei dann, wenn die Dotierung p+ ist, der effektive Gap in erster Ordnung an den Gap angeglichen ist, wobei die vergrabenen leitfähigen Leitungen elektrisch mit dem Umfangssubstratkontakt verbunden und zwischen zwei benachbarten Spalten von Dioden und zwischen zwei benachbarten Zeilen von Dioden positioniert sind und sich an einem Schnittpunkt derart kreuzen, dass sie ein Netz von vergrabenen leitfähigen Leitungen bilden,
**dadurch gekennzeichnet, dass** die vergrabenen leitfähigen Leitungen aus dem oder den gleichen chemischen Elementen gebildet sind wie das Halbleitermaterial des Substrats und mit einem Dotierelement dotiert sind, genannt Leitungsdotierstoff, der mit einer Dichte vorhanden ist, die zwischen $10^{15}$ und $10^{20}$ at/cm$^3$ enthalten ist.

2. Vorrichtung nach Anspruch 1, bei der die vergrabenen leitfähigen Leitungen aus einem degenerierten Halbleitermaterial sind.

3. Vorrichtung nach einem der Ansprüche 1 oder 2, bei der das Substrat aus einem Material auf Basis von $Hg_{1-x}Cd_xTe$ ist, und der Leitungsdotierstoff als Funktion des gewünschten Dotiertyps in der vergrabenen leitfähigen Leitung Arsen oder Bor ist.

4. Vorrichtung nach einem der Ansprüche 1 bis 3, bei der das Substrat aus einem Material auf Basis von $Hg_{1-x}Cd_xTe$ ist, das zwischen zwei benachbarten Dioden eine erste Zusammensetzung aus Cadmium hat, und bei der die vergrabenen leitfähigen Leitungen eine Dotierung vom Typ "p" haben und eine zweite Zusammensetzung aus Cadmium höher als die erste Zusammensetzung haben.

5. Vorrichtung nach einem der Ansprüche 1 bis 4, bei der die vergrabenen leitfähigen Leitungen in dem Substrat sind und mit einer Hauptoberfläche des Substrats auf einer Seite fluchten, wo die Dioden vorgesehen sind, wobei die Oberfläche eine Grenzfläche zwischen dem Substrat und einer dielektrischen Schicht sein kann, die die Dioden und das Substrat bedeckt.

6. Vorrichtung nach einem der Ansprüche 1 bis 4, bei der die vergrabenen leitfähigen Leitungen in dem Substrat auf der Seite einer Hauptoberfläche des Substrats vergraben sind, wo die Dioden vorgesehen sind, wobei die vergrabenen leitfähigen Leitungen von dieser Hauptoberfläche durch eine gegebene Dicke von Substratmaterial getrennt sind, wobei die Oberfläche eine Grenzfläche zwischen dem Substrat und einer dielektrischen Schicht sein kann, die die Dioden und das Substrat bedeckt.

7. Vorrichtung nach einem der Ansprüche 1 bis 6, umfassend eine vergrabene leitfähige Leitung zwischen zwei benachbarten Spalten von Dioden und/oder zwei benachbarten Zeilen von Dioden wenigstens alle k Spalten und/oder m Zeilen der Matrix, wobei k und m den Wert Dreißig, Zwei oder Eins haben.

8. Vorrichtung nach einem der Ansprüche 1 bis 7, bei der jede vergrabene leitfähige Leitung zwischen zwei benachbarten Zeilen oder zwei benachbarten Spalten mit gegebenen Längen eine Länge aufweist, die größer oder gleich den Längen der Spalten oder Zeilen ist.

9. Vorrichtung nach einem der Ansprüche 1 bis 8, bei der die vergrabenen leitfähigen Leitungen eine Länge und eine Breite haben, definiert in einer Ebene, die die Dioden enthält, wobei die Breite orthogonal zur Länge ist und zwischen ungefähr 0,5 $\mu$m und 5 $\mu$m enthalten ist.

10. Vorrichtung nach einem der Ansprüche 1 bis 9, bei der die vergrabenen leitfähigen Leitungen eine Dicke haben, definiert im Wesentlichen entlang einer Normalen zu einer Ebene, die die Dioden enthält, die zwischen ungefähr 0,5 $\mu$m und 2 $\mu$m enthalten ist.

11. Vorrichtung nach einem der Ansprüche 1 bis 10, bei der ein oder mehr Näherungssubstratkontakte in elektrischem Kontakt mit wenigstens einer vergrabenen leitfähigen Leitung vorhanden und elektrisch mit dem Umfangssubstratkontakt durch elektrische Verbindungen verbunden sind, die von den vergrabenen leitfähigen Leitungen verschieden sind, wobei der oder die Näherungssubstratkontakte zwischen zwei benachbarten Zeilen und/oder benachbarten Spalten eingesetzt sein können, oder eine Diode ersetzen können.

## Claims

1. A device including a substrate in a semi-conductor material carrying an array of diodes, organized into rows and columns, and a peripheral substrate contact arranged on at least one side of the array, the substrate having a first doping type and the diodes including in the substrate, a second doped zone having a second doping type, opposite to the first type, the substrate being of Si or SiC or SiGe or a $Hg_{1-x}Cd_xTe$ based material or being a semi-conductor on insulator substrate SOI, the substrate comprising several other doped zones, each forming a buried conducting line, each buried conducting line flushes with a main surface of the substrate on the side where the diodes are present, or being separated from this main surface by a given thickness of material of the substrate, these other doped zones having the first doping type and a greater doping density than in the substrate, the buried conducting lines having a band gap higher than that of the substrate when the buried conducting lines are of degenerate semi-conductor material or an effective gap higher than that of the substrate when the buried conducting lines are of degenerate semi-conductor material, wherein the Fermi level is situated in a band among the conduction band and the valence band and the position is function of the doping, wherein, when the doping is of n+ type with a Fermi level situated in the conduction band, the effective gap is the energy difference between the Fermi level situated in the conduction band and the corresponding state of the direct transition in the valence band of the first order is assimilated to the top of the valence band and, wherein the doping is of the p+ type, the effective gap being assimilated to the first order gap, the buried conducting lines being electrically connected to the peripheral substrate contact and positioned between two neighboring columns of diodes (Di) and crossing at an intersection and forming a meshing of buried conducting lines, *characterized in that* the buried conducting lines consist of the same chemical element(s) as the semi-conductor material of the substrate (51) and are doped with a doping element, called a line dopant present with a density between $10^{15}$ and $10^{20}$ at/cm$^3$.

2. The device according to claim 1, wherein the buried conducting lines are of degenerate semi-conductor material.

3. The device according to one of claims 1 or 2, wherein the substrate is of a $Hg_{1-x}Cd_xTe$ based material and the line dopant is arsenic or boron as a function of the doping type wanted in the buried conducting lines.

4. The device according to one of claims 1 to 3, wherein the substrate is of a $Hg_{1-x}Cd_xTe$ based material having, between two neighbouring diodes, a first cadmium composition, and wherein the buried conducting lines have a "p"-type doping and have a second cadmium composition higher than the first composition.

5. The device according to one of claims 1 to 4, wherein the buried conducting lines are in the substrate and are flush with a main surface of the substrate on the side where the diodes are present, wherein said surface can be an interface between the substrate and a dielectric layer covering the diodes and the substrate.

6. The device according to one of claims 1 to 4, wherein the buried conducting lines are buried in the substrate on the side of a main surface of the substrate where the diodes are present, the buried conducting lines being separated from this main surface by a given thickness of material of the substrate, wherein said surface can be an interface between the substrate and a dielectric layer covering the diode and the substrate.

7. The device according to one of claims 1 to 6, including a buried conducting line between two neighboring columns of diodes and/or two neighboring rows of diodes at least every k columns and/or m rows of the array, wherein k and m are thirty, two or one.

8. The device according to one of claims 1 to 7, wherein each buried conducting line present between two neighboring rows or between two neighboring columns of given length, has a length equal to or higher than the length of said columns or said rows.

9. The device according to one of claims 1 to 8, wherein the buried conducting lines have, being defined in a plane containing the diodes, a length and a width, the width being perpendicular to the length and between about 0.5 $\mu$m and 5 $\mu$m.

10. The device according to one of claims 1 to 9, wherein the buried conducting lines have a thickness, substantially defined along a normal to a plane containing the diodes, between about 0.5 $\mu$m and 2 $\mu$m.

11. The device according to one of claims 1 to 10, wherein one or several close substrate contacts are present, electrically contacting at least one buried conducting line and electrically connected to the peripheral substrate contact by electrical connections other than the buried conducting lines, wherein the closer substrate contacts can be inserted between two neighboring rows and/or neighboring columns and can be in replacement of a diode.

FIG 1A

FIG 1B

34.0

5.0

9.0

4.0

3.0

1.0

10.0

2.0

**FIG 2**

5.1

A

D2

P2

20

Di

P1

A'

**FIG 3A**

FIG 3B

FIG 3C

FIG 4A

EP 2 786 411 B1

FIG 4B

FIG 5A

FIG 5B

FIG 6

FIG 7

FIG 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2011227091 A
- EP 1677353 A1
- US 20100148289 A1
- EP 2315251 A1

**Littérature non-brevet citée dans la description**

- **M.A. KINCH et al.** 1/f noise in HgCdTe Photodiodes. *Journal of electronic Material,* 2008, vol. 34 (6), 928
- **J.M. ARIAS et al.** MBE HgCdTe Heterostructure p-on-n Planar Infrared Photodiodes. *Journal of electronic Material,* 1993, vol. 22 (8), 1049